# EUROPEAN PATENT APPLICATION

(11) **EP 4 656 587 A1**
(43) Date of publication of application: **03.12.2025**
(21) Application number: 24179243.1
(22) Date of filing: 31.05.2024
(51) Int. Cl.: B81B 7/00

(54) **MEMS DEVICE AND METHOD FOR FABRICATING A MEMS DEVICE**

(71) Applicant: Infineon Technologies AG, 85579 Neubiberg (DE)
(72) Inventor: Anzinger, Sebastian, 83714 Miesbach (DE); Wasisto, Hutomo Suryo, 81541 München (DE); Fueldner, Marc, 85579 Neubiberg (DE); Geissler, Stefan, 93059 Regensburg (DE); Arpiainen, Sanna, 93047 Regensburg (DE)
(74) Representative: Hersina, Günter

(57) **Abstract**

A MEMS device (10) comprises a functional element (12) in a fluidic connection with the environment, wherein the functional element (12) comprises an overall surface area (50) with at least a first subsection (50-1) and an adjacent second subsection (50-2), wherein the functional element (12) is in the first subsection (50-1) of the overall surface area (50) less prone to a surface contamination (48) than in the second subsection (50-2) of the overall surface area (50); and wherein the first subsection (50-1) of the overall surface area (50) has a first surface structure (52) with a higher liquid wettability than a second surface structure (54) of the second subsection (50-2) of the overall surface area (50).

## Description

Embodiments of the present disclosure relate to a microelectromechanical system (MEMS)-based device and a method for fabricating a MEMS-based device. More specifically, embodiments relate to the field of MEMS sensors or MEMS actuators, e.g., MEMS sound transducers (MEMS microphones or MEMS loudspeakers), MEMS pressure sensors, MEMS gas sensors, MEMS environmental sensors, or, in general, MEMS devices having an environmentally robust design enabled by providing locally hydrophobicity gradients or differences on a surface area of a functional element of the MEMS device. Further, embodiments also relate to a combination of a hydrophilic and a hydrophobic surface coating (surface structure) for a functional element of a MEMS device, e.g., a MEMS sound transducer (MEMS microphone or MEMS loudspeaker) to increase the environmental robustness, and to a method for fabricating such a MEMS device.

### Technical Background

MEMS-based devices gain more and more importance in the sensing of physical, mechanical, chemical, and environmental parameters in the ambient atmosphere. MEMS devices, such as MEMS sound transducers or MEMS pressure sensors function essentially as a transducer element converting a static pressure change or an acoustic pressure wave into an analog electrical signal in response to a deflection of a membrane of the MEMS device.

When designing MEMS devices having a (deflectable) functional element in a fluidic connection with the environment, it is typically desirable that the MEMS device is specified to be immersion proof. Immersion proof generally means that an immersion of the MEMS device and, especially, of the functional element of the MEMS device into a liquid (e.g., deionized (DI) water, distilled water, tap-water, oil, and other liquids) does not result in a deterioration of an operational characteristic of the functional element. However, a surface contamination with liquid residuals or contaminants, e.g., water residuals in form of salt, chalk, or other types of particles, as a result of a surface drying process after an exposure of the surface area of the functional element to the liquid can result in a significant deterioration of an (electrical or mechanical) operational characteristic of the functional element of the MEMS device.

Therefore, there is an ongoing need in the field of MEMS devices to implement a MEMS device having a functional element in a fluidic connection with the environment in that a surface contamination, e.g., as a result of a surface drying of the functional element after exposure to a liquid (e.g. tap-water) of the surface area of the functional element does not result in a significant deterioration of an (electrical or mechanical) operational characteristic, e.g., sensitivity, noise, signal-to-noise ratio (SNR), corner frequency, compliance (flexibility), etc., of the functional element.

Such a need can be solved by the MEMS device according to independent claim 1 and the MEMS device fabricated by means of the fabrication method according to independent claim 12.

Further, specific implementations of the MEMS device are defined in the dependent claims.

### Summary

According to an embodiment, a MEMS device comprises a (deflectable) functional element in a fluidic connection with the environment, wherein the functional element comprises an overall surface area with at least a first subsection and an adjacent second subsection, wherein the functional element is (configured to be) in the first subsection of the overall surface area less prone to a surface contamination than in the second subsection of the overall surface area, and wherein the first subsection of the overall surface area has a first surface structure with a higher liquid wettability than a second surface structure of the second subsection of the overall surface area.

According to an embodiment, the overall surface area of the functional element is configured, so that a surface contamination of the first subsection as a result of a surface drying of the functional element after an exposure to a liquid can lead to a smaller deterioration of an electrical or mechanical characteristic of the functional element when compared to a corresponding surface contamination of the second subsection.

According to an embodiment, the overall surface area comprises a (topographical) difference or gradient of a liquid contact angle on the overall surface area resulting in the first and second subsections having the different liquid wettabilities. The term topography refers in the present description of both the geometric shape and the physical and chemical properties of the (technical) surface structures, e.g. nano- or micro-structures, of the functional element.

According to an embodiment, the first subsection of the overall surface area is configured to form a liquid collection region during a liquid drying event of the overall surface area of the functional element. The second subsection of the overall surface area is configured to form a liquid repelling region during a liquid drying event of the overall surface area of the functional element.

In accordance to the different embodiments, the term "less prone" (= less susceptible) to a surface contamination, e.g., as result of surface drying after exposure to a liquid, generally means in the context of the present disclosure that a surface contamination of the first subsection of the overall surface area results in a lower deterioration of an electrical or mechanical characteristic, e.g., an operational characteristic, of the functional element than a (comparable or equal) surface contamination of the second subsection of the overall surface area, e.g. as result of surface drying after exposure to the liquid.

An (electrical or mechanical) operational characteristic of the functional element is, for example, the sensitivity, the membrane compliance (flexibility), the achievable SNR, the internal resistance, the parasitic capacitance, etc. of the functional element.

According to an embodiment, a fabrication method comprises the steps of providing a MEMS device having a functional element in a fluidic connection with the environment, wherein the functional element comprises an overall surface area with a first subsection and an adjacent second subsection, and of providing (e.g. forming) a first surface structure on the first subsection of the overall surface area having a higher liquid wettability than a second surface structure on the second subsection of the overall surface area.

According to an embodiment, a fabrication method comprises the step of forming a (topographical) difference or gradient of the liquid contact angle on the overall surface area for providing the first and second subsections having the different liquid wettabilities.

The inventors of the present disclosure have observed and recognized that an immersion of a MEMS device having a deflectable functional element in a fluidic connection with the environment into a liquid, e.g., tap-water, can cause a significant deterioration of an electrical or mechanical characteristic, e.g., an operational characteristic, of the functional element and, thus, of the MEMS device.

A surface drying of the functional element after an exposure of the functional element to a liquid, e.g., tap-water, can result in an accumulation or sedimentary deposition of liquid residuals on the surface area of the functional element of the MEMS device. Such a surface contamination of the functional element with liquid residuals or contaminants, e.g., water residuals in form of salt, chalk, or other particles, etc. as a result of a surface drying process after an exposure of the surface area of the functional element to the liquid, e.g., tap-water, can, for example, provide a leakage between electrically separated segments of the functional element, a leakage between (electrically isolated) conductive traces on the surface area of the functional element, a leakage between the functional element and the substrate (or other electrically conductive structures of the MEMS device), a mechanical blocking of through holes (ventilation holes) of the functional element etc. or another deterioration of an (electrical or mechanical) operational characteristic of the functional element. The functional element may comprise a deflectable membrane of a MEMS sensor, MEMS actuator or a MEMS environmental sensor, e.g. a deflectable membrane structure of a sound transducer (microphone and/or loudspeaker), or of a MEMS pressure sensor, etc. Thus, the functional element may comprise a transducing (e.g. sensing and/or actuating) MEMS element.

The inventors of the present disclosure have further recognized, e.g. from optical micrographs, that a higher number or larger area of contaminants on the functional element do not necessarily result in higher failure rates of the functional element of the MEMS device. Only contaminants at specific "critical" regions (= second subsection(s) of the overall surface area) of the functional element actually cause a damage of the functional element of the MEMS device or a significant deterioration of an (electrical or mechanical) operational characteristic of the functional element of the MEMS device or even a damage or malfunction (functional failure) of the functional element of the MEMS device. Such a deterioration or damage etc. can result from an electrical leakage between (electrically separated) surface regions of the functional element or between a surface region of the functional element and a further electrically conductive structure of the MEMS device, wherein, as a consequence of an electrical leakage, a failure in the SNR of the MEMS device can occur.

However, a contamination does not cause failures (damages or malfunctions) on most parts (= first subsection(s)) of the surface region of the functional element, e.g., of a membrane structure, so that only specific regions (= the second subsection(s)) of the surface area of the functional element need to be kept "clean" from a surface contamination, e.g., as a result from a surface drying process after an exposure of the surface to a liquid, e.g., tap-water.

Thus, the first subsection of the overall surface of the functional element has a first surface structure with a higher liquid wettability than a second surface structure of the second subsection of the overall surface area of the functional element. Thus, the hydrophobicity of the involved materials of the functional element of the MEMS device can be controlled to direct the movement of the liquid together with the contaminants therein (during a drying process of the functional element after an exposure to a liquid) to distinct (predefined) drying regions on the surface area of the functional element. Thus, critical surface regions (the second subsection) of the functional element can be kept clean (free) from the contaminants in the liquid.

Thus, according to the present disclosure, the functional element of the MEMS device may comprise along its overall surface area a liquid contact angle gradient or a liquid contact angle gradient difference (or liquid contact angle gradients / differences), wherein the more hydrophilic parts of the surface area of the functional element, i.e., the first subsection(s) of the overall surface area (having a higher liquid wettability than the second surface structure of the second subsection of the overall surface area) acts or functions as a "water/liquid collection" region during the drying process of the functional element after an exposure of the surface area of the functional element to a liquid, e.g., tap-water.

Thus, the present approach of the MEMS device with the functional element having specifically selected subsections of the overall surface area of the functional element with a higher liquid wettability than the remaining subsections of the overall surface area of the functional element allows to fabricate MEMS devices, e.g., MEMS sound transducers or other MEMS sensors or MEMS actuators, with an enhanced environmental robustness level, especially towards water immersion and electrical leakage caused by particles or contaminants as result of a surface drying after exposure to the liquid.

According to the present embodiments, the functional element of the MEMS device has a liquid contact angle gradient or difference (or a water contact angle (WCA) gradient or difference) along its surface area, wherein the more hydrophilic parts (= the first subsections) of the surface area act as "liquid collection" regions (water collection regions) during the drying process. According to an embodiment, the second subsection(s) of the overall surface area may form a liquid "repelling" region during a liquid drying event of the overall surface area of the functional element.

Thus, the MEMS device according to the present disclosure may allow to build liquid-proof (water-proof) MEMS devices, e.g., MEMS microphones, without the need of an external environmental barrier. Thus, the module costs for the liquid-proof (water-proof) MEMS device can be significantly reduced.

Based on the enhanced liquid (water) immersion resistance of the MEMS device, an external environmental barrier can be avoided or, automatically, a less liquid-resistant (water-resistant) external environmental barrier could be used, wherein both cases would enhance the operational characteristics of the MEMS device, e.g., the system SNR, and would lower the resulting module costs for the MEMS device.

### Brief Description of the Figures

In the following, embodiments of the present disclosure are described in more detail while making reference to the accompanying drawings, in which:
- Figs. 1a: shows a schematic cross-sectional view of a MEMS device in accordance with an embodiment of the present disclosure;
- Figs. 1b-c: show a schematic cross-sectional view and a schematic top (plane) view of a MEMS device in form of a MEMS microphone in accordance with an embodiment of the present disclosure;
- Fig. 2: shows an exemplary schematic flow chart of a fabrication method of the MEMS device according to an embodiment of the present disclosure;
- Figs. 3a-d: show schematic cross-sectional views of a partial section of the surface area of the functional element of the MEMS device according to embodiments of the present disclosure during a drying process after an exposure of the functional element to a liquid;
- Figs. 4a: shows a schematic cross-sectional view of the MEMS device with an exemplary implementation of the surface structure of the functional element in accordance with a further embodiment of the present disclosure;
- Fig. 4b: shows an enlarged schematic cross-sectional partial view of the MEMS device with an exemplary implementation of the surface structure of the functional element in accordance with a further embodiment of the present disclosure;
- Fig. 5a-c: show an exemplary schematic flow chart of an implementation of the fabrication method 100 for providing the MEMS device having a functional element with the different (first and second) surface structures of the overall surface area according to an embodiment of the present disclosure;
- Figs. 6a-b: show a schematic cross-sectional view and an enlarged schematic crosssectional partial view of the MEMS device with an exemplary implementation of the surface structure of the functional element in accordance with a further embodiment of the present disclosure;
- Figs. 7a-c: show a schematic cross-sectional view and enlarged schematic crosssectional partial views of the MEMS device with an exemplary implementation of the surface structure of the functional element in accordance with a further embodiment of the present disclosure;
- Figs. 8a-c: show a schematic cross-sectional view of the MEMS device with an exemplary implementation of the surface structure of the functional element, an enlarged schematic cross-sectional partial view of the surface structure of the functional element and a schematic top (plane) view of the surface structure of the functional element in accordance with a further embodiment of the present disclosure;
- Figs. 9a-c: show a schematic cross-sectional view of the MEMS device with an exemplary implementation of the surface structure of the functional element, an enlarged schematic cross-sectional partial view of the surface structure of the functional element and a schematic top (plane) view of the surface structure of the functional element in accordance with a further embodiment of the present disclosure;
- Fig. 10a-d: show an exemplary schematic flow chart of a fabrication method of the surface structure of the functional element of the MEMS device according to a further embodiment of the present disclosure;
- Figs. 11: shows a schematic cross-sectional view of the MEMS device with an exemplary implementation of the surface structures of the functional element in accordance with a further embodiment of the present disclosure;
- Figs. 12: shows a schematic cross-sectional view of the MEMS device with an exemplary implementation of the surface structures of the functional element in accordance with a further embodiment of the present disclosure;
- Fig. 13a-c: show an exemplary schematic flow chart of a fabrication method of the surface structure of the functional element of the MEMS device according to a further embodiment of the present disclosure;
- Fig. 14a-e: show an exemplary schematic flow chart of a fabrication method of the surface structure of the functional element of the MEMS device according to a further embodiment of the present disclosure;
- Fig. 15a-d: show an exemplary schematic flow chart of a fabrication method of the surface structure of the functional element of the MEMS device according to a further embodiment of the present disclosure;
- Figs. 16a-c: show a schematic cross-sectional view of the MEMS device with an exemplary implementation of the surface structure of the functional element in accordance with a further embodiment of the present disclosure; and
- Fig. 17a-e: show an exemplary schematic flow chart of a fabrication method of the surface structure of the functional element of the MEMS device according to a further embodiment of the present disclosure;

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of the field of MEMS devices, e.g., MEMS sensors or actuators or dual-membrane MEMS sensors or actuators. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e., is parallel, to a first main surface region of a substrate or the (undeflected) surface area of the functional element (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e., parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets next to a described element or function are to be understood as further explanations, exemplary configurations, exemplary additions and/or exemplary alternatives of the described element or function.

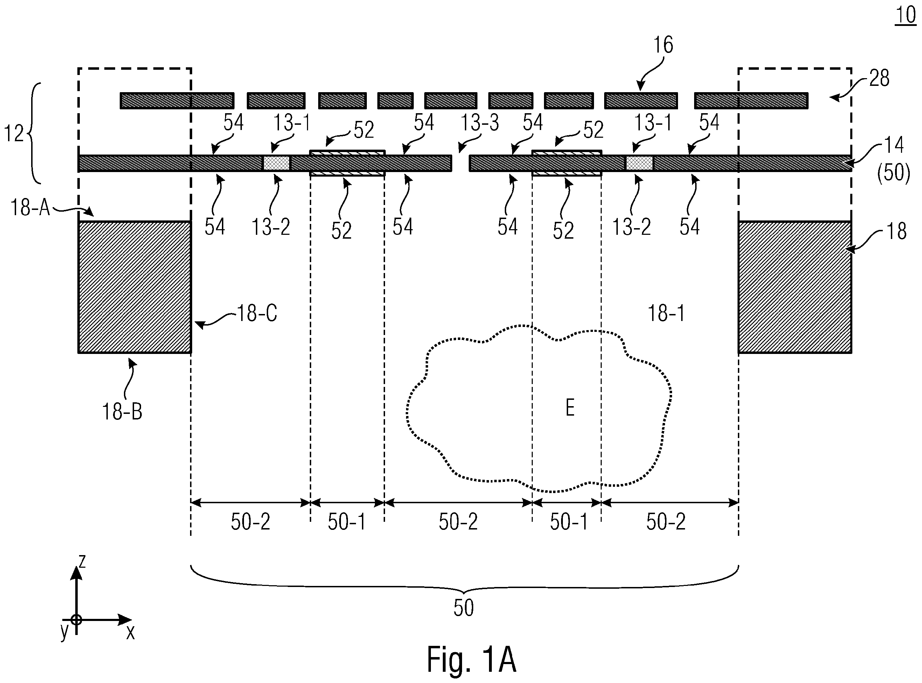

Figs. 1a shows a schematic cross-sectional view of a MEMS device 10 in accordance with an embodiment of the present disclosure. The MEMS device 10 may be arranged as a SBP (single backplate) structure, e.g. a single backplate or single membrane sound transducer 10.

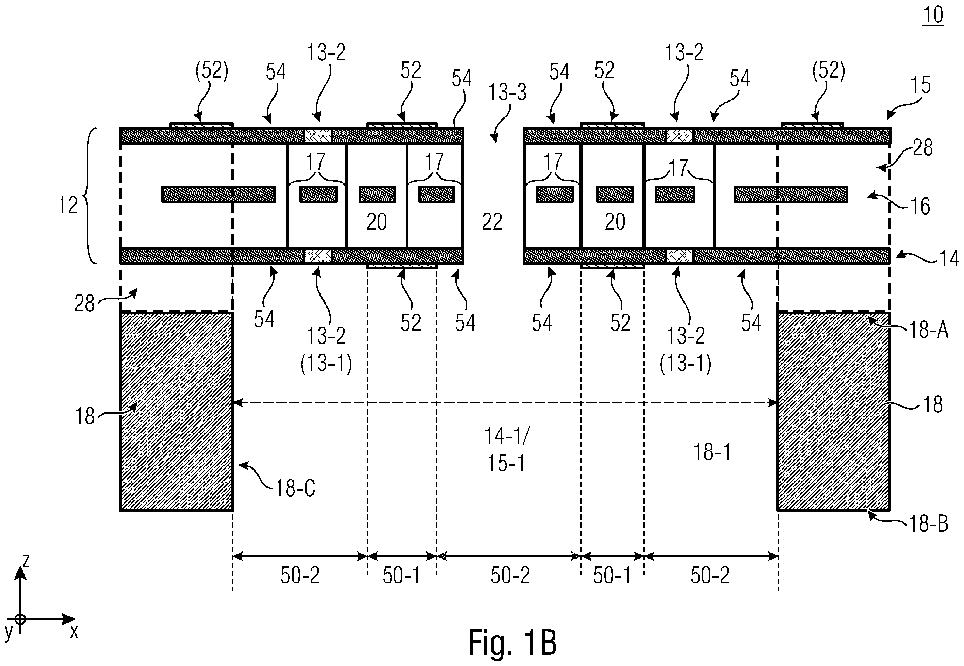

Figs. 1b-c show a schematic cross-sectional view and a schematic top (plane) view of a MEMS device 10 in accordance with a further embodiment of the present disclosure. Fig. 1b-c and the following figures exemplarily show the MEMS device 10 in form of a dual membrane MEMS microphone or a sealed dual membrane (SDM) MEMS microphone according to various embodiments of the present disclosure. However, the following specification of the MEMS device 10 is equally applicable to any MEMS sensor, MEMS actuator or MEMS environmental sensor, wherein the MEMS device 10 comprises a (deflectable) functional element 12, e.g. having a membrane structure 14, in a fluidic connection with the environment. According to an embodiment, the functional element 12 of the MEMS device 10 (MEMS sensor or MEMS actuator) may be part of a transduction operation based on a capacitive, piezoelectric or piezoresistive transducing (sensing or actuating) mechanism, or based on an optical sensing mechanism.

According to the embodiment as shown in Figs. 1a-c, the MEMS device 10 comprises a functional element 12 in a fluidic connection (communication) with the environment "E". The functional element 12, which may comprise a deflectable structure 14, e.g., a membrane structure, comprises an overall surface area 50 with at least a first subsection 50-1 and an adjacent or directly adjacent second subsection 50-2. The functional element 12 is configured (arranged) to be in the first subsection 50-1 of the overall surface area 50 less prone to a surface contamination than in the second subsection 50-2 of the overall surface area 50. The first subsection 50-1 of the overall surface area 50 has a first surface structure 52 with a higher liquid wettability than a second surface structure 54 of the second subsection 50-2 of the overall surface area 50.

According to an embodiment, the overall surface area 50 of the functional element 12 may be configured, so that a surface contamination of the first subsection 50-1 as a result of a surface drying of the functional element 12 after an exposure to a liquid results in a smaller deterioration of an electrical or mechanical characteristic of the functional element 12 when compared to a corresponding surface contamination of the second subsection 50-2.

According to an embodiment, the overall surface area 50 of the functional element 12 relates to an exposed portion of the surface area of the functional element 12, which is in a fluidic (gas and liquid) connection with the environment.

In accordance to the present disclosure, the surface characteristic "less prone (less susceptible) to a surface contamination" means that a surface contamination, e.g. as result of surface drying after exposure to a liquid, of the first subsection 50-1 of the overall surface area 50 results in a lower deterioration of an (electrical or mechanical) operational characteristic, e.g. of the sensitivity, membrane compliance, the SNR (signal-to-noise ratio), internal resistance, parasitic capacitances, etc. of the functional element 12 than a (comparable) surface contamination, e.g. as result of the surface drying after exposure to the liquid, of the second subsection 50-2 of the overall surface area 50.

The first subsection 50-1 of the overall surface area 50 may be regarded as a (specific) "uncritical" region of the functional element 12, where a surface contamination, e.g., as result of surface drying after exposure to a liquid, would not effect a (significant) deterioration of an operational characteristic of the functional element 12, or a functional failure or malfunction of the functional element 12 and, consequently, of the MEMS device 10.

The second subsection 50-2 of the overall surface area 50 may be regarded as a (specific) "critical" region of the functional element 12, where a surface contamination, e.g., as result of surface drying after exposure to a liquid, would effect a (significant) deterioration of an operational characteristic of the functional element 12, or even a functional failure or malfunction of the functional element 12 and, consequently, of the MEMS device 10.

According to an embodiment, a (significant) deterioration of an operational characteristic of the functional element 12, e.g., a reduced SNR of the MEMS device 10, may be avoided by preventing an accumulation or sedimentary deposition of liquid residuals on the second subsection(s) 50-2 of the surface area 50 of the functional element 12 (e.g., as result of a surface drying of the functional element 12 after an exposure of the functional element 12 to a liquid, e.g., tap-water, which could otherwise result in an electrical leakage between (usually) electrically separated regions of the functional element 12 of the MEMS device 10 in the second subsection 50-2 of the overall surface area 50.

The following embodiments relate to possible implementations and realizations of the different liquid wettabilities of the first and second subsections 50-1, 50-2 of the overall surface area 50 of the functional element 12.

According to an embodiment, the overall surface area 50 may comprise a (topographical) difference or gradient of a liquid contact angle on the overall surface area resulting in the first subsection(s) 50-1 and the second subsection(s) 50-2 having the different liquid wettabilities.

According to an embodiment, the first subsection(s) 50-1 of the overall surface area 50 may form a liquid collection region during a liquid drying event of the overall surface area 50 of the functional element 12. According to an embodiment, the second subsection(s) 50-2 of the overall surface area 50 may form a liquid "repelling" region during a liquid drying event of the overall surface area 50 of the functional element 12.

Due to the higher liquid wettability of the first subsection(s) 50-1 (uncritical areas) of the overall surface area 50 when compared to the second subsection(s) 50-2 (critical areas) of the overall surface area 50, liquid droplets (with the contaminants) will move during a drying process of the functional element 12 after an exposure to the liquid from to the second subsection(s) 50-2 (critical areas) of the overall surface area 50 to the first subsection(s) 50-1 (uncritical areas) of the overall surface area 50 and/or may stay in the first subsection(s) 50-1 (uncritical areas) of the overall surface area 50. Thus, after drying the droplets, a contamination of the second subsection(s) 50-2 (critical areas) of the overall surface area 50 of the functional element 12 may be avoided.

According to the present disclosure, the first subsection 50-1 of the overall surface 50 of the functional element 12 has the first surface structure 52 (the first surface characteristic) with a higher liquid wettability than the second surface structure 54 (the second surface characteristic) of the second subsection 50-2 of the overall surface area 50 of the functional element 12. Thus, the hydrophobicity of the involved materials of the functional element 12 of the MEMS device 10, which provide the different surface structures or surface characteristics of the functional element 12, can be controlled to direct the movement of a liquid or liquid droplets together with the contaminants therein, e.g., during a drying process of the functional element 12 after an exposure to the liquid, to distinct (predefined) drying regions, i.e. to the first subsection(s) 50-1 of the overall surface area 50, of the functional element. Thus, the "critical" surface regions, i.e. the second subsection 50-2 of the overall surface area 50, of the functional element 12 can be kept clean (free) from the contaminants in the liquid.

Thus, according to the present disclosure, the functional element 12 of the MEMS device 10 may comprise along its overall surface area 50 a liquid contact angle gradient or a liquid contact angle (LCA) gradient difference (or LCA gradients / differences), wherein the more hydrophilic parts 50-1 of the surface area 50 of the functional element 12, i.e., the first subsection(s) 50-1 of the overall surface area 50, which have a higher liquid wettability than the second surface structure of the second subsection 50-2 of the overall surface area 50, act (function) as a "liquid collection" region during the drying process of the functional element 12 after an exposure of the surface area 50 of the functional element 12 to a liquid, e.g. tap-water.

According to an embodiment, the first surface structure of the first subsection 50-1 may comprise a lower liquid contact angle (LCA) or a lower water contact angle (WCA) than the second surface structure of the second subsection 50-2 of the overall surface area 50. A small contact angle of less than 90° may be regarded to correspond to a high wettability or hydrophilicity, whereas a large contact angle of more than 90° may be regarded to correspond to a low wettability or hydrophobicity.

According to the present disclosure, the overall surface area 50 of the functional element 12 comprises a wettability gradient between the first subsection 50-1 and the second subsection 50-2, wherein this wettability gradient can direct a droplet's motion without any external force to the first subsection(s) 50-1 (uncritical areas) of the overall surface area 50. Thus, the droplets containing particles can then be transported/manipulated in terms of its position by having different subsections 50-1, 50-2 with different wettabilities 52, 54 on the surface area 50.

According to an embodiment, the first surface structure of the first surface subsection 50-1 may have a hydrophilic surface characteristic and the second surface structure of the second surface subsection 50-2 may have a hydrophobic surface characteristic.

In the context of the present description, the terms "first (hydrophilic) surface structure 52 of the first surface subsection 50-1" and "second (hydrophobic) surface structure 54 of the second surface subsection 50-2" of the functional element 12 may also mean that, according to an embodiment, the first surface structure 52 of the first surface subsection 50-1 may comprise a lower hydrophobic surface characteristic than the second surface structure 54 of the second surface subsection 50-2, or according to a further embodiment, the first surface structure 52 of the first surface subsection 50-1 may comprise a higher hydrophilic surface characteristic than the second surface structure 54 of the second surface subsection 50-2.

Thus, the present approach of the MEMS device with the functional element 12 having specifically selected subsections 50-1 of the overall surface area 50 of the functional element 12 with a higher liquid wettability than the remaining subsections 50-2 of the overall surface area 50 of the functional element 12 allows to fabricate MEMS devices 10, e.g., MEMS sound transducers or other MEMS sensors or MEMS actuators, with an enhanced environmental robustness level, especially towards liquid (e.g. water) immersion and electrical leakage caused by particles or contaminants as result of a surface drying after exposure to the liquid.

As the functional element 12 of the MEMS device 10 has a surface region 50-1 that acts as "liquid collection" regions (water collection regions) during the drying process, liquid-proof (water-proof) MEMS devices, e.g. MEMS sound transducers, may be built without the need of an external environmental barrier. Thus, the module costs for the MEMS device 10 can be significantly reduced.

Based on the enhanced liquid immersion resistance of the MEMS device 10, an external environmental barrier can be avoided or, alternatively, a less liquid-resistant (water-resistant) external environmental barrier could be used, wherein both cases would enhance the operational characteristics of the MEMS device 10, e.g. the system SNR, and would lower the resulting module costs for the MEMS device 10. An external environmental barrier is usually used to try to reduce or to avoid a contact of a functional element of A MEMS device with water or any liquid from the environment.

According to an embodiment, the functional element 12 may comprise in the second subsection at least one of an electrically, mechanically and/or fluidically operating element 13. Thus, the functional element 12 may comprise in the second subsection 50-2 of the overall surface area 50 at least one of a conductive trace 13-1, a dielectric segmentation line 13-2 or a ventilation hole 13-3.

During a liquid drying event of the overall surface area 50 of the functional element 12, the first subsection 50-1 of the overall surface area 50 may form a liquid collection region, wherein the second subsection 50-2 of the overall surface area 50 may form a liquid "repelling" region. Therefore, the MEMs device 10 having the functional element 12 as described above can avoid or at least strongly reduce a surface contamination of the second subsection 50-2 of the overall surface area 50 of the functional element 12 with liquid residuals, e.g. water residuals in form of salt, chalk, etc. as a result of a surface drying process after an exposure of the surface area 50 of the functional element 12 to a liquid, e.g. tap-water. Consequently, the MEMs device 10 having the functional element 12 can avoid or at least strongly reduce a leakage between electrically separated segments of the functional element (e.g. a microphone membrane), a leakage between (electrically isolated) conductive traces on the surface area of the functional element, a leakage between the functional element (e.g. of a microphone membrane) and the substrate (or other electrically conductive structures of the MEMS device), a mechanical blocking of through holes (ventilation holes) of the functional element, etc.

According to an embodiment, the first (hydrophilic) surface structure 52 of the first surface subsection 50-1 of the functional element 12 may comprise at least one of nano- or micro-pillars, a locally deposited or patterned self-assembled monolayer (SAM), a selectively laser-processed surface structure, a nanoparticle structure, e.g. applied by Inkjet printing, a nano-patterning, a nano-patterning combined with a liquid or lubricant infusion, a nano-patterning combined with a SAM coating, and a structure of printed hydrophobic nanoparticles or SAMs.

According to an embodiment, the second (hydrophobic) surface structure 54 of the second surface subsection 50-2 of the functional element 12 may comprise at least one of nano- or micro-pillars, a locally deposited or patterned SAM, a selectively laser-processed surface structure, a nanoparticle structure (e.g., applied by inkjet printing), a nano-patterning, a nano-patterning combined with a liquid or lubricant infusion, a nano-patterning combined with a SAM coating, and a structure of printed hydrophilic nanoparticles or SAMs.

According to a further embodiment, the first and second subsections 50-1, 50-2 having the different liquid wettabilities of the functional element 12 may be achieved by different materials for the functional element 12 which have different wettabilities, liquid/water contact angles or hydrophobicities (e.g., Si vs. SiN).

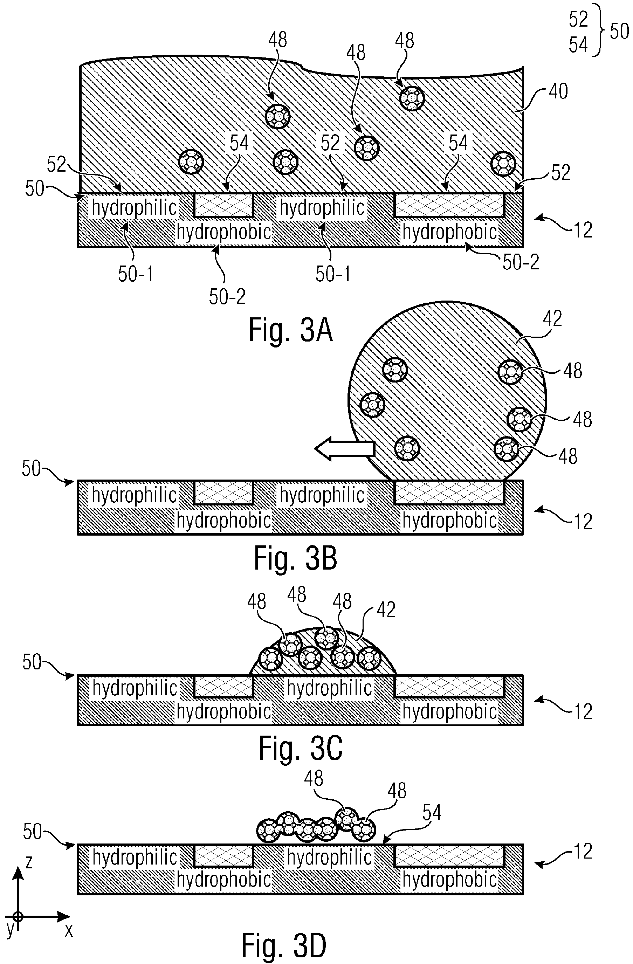

The first surface structure of the first surface subsection 50-1 and the second surface structure of the second surface subsection 50-2 of the functional element 12 are described in further detail based on the following figures 3 to 16, for example.

As exemplarily shown in Fig. 1a, the MEMS device 10 comprises a functional element 12 having a deflectable membrane structure 14. The MEMS device 10 may also optionally comprise a rigid electrode structure 16, e.g. for providing a capacitive transducing mechanism, in a vertically (= along the z-direction) spaced and overlapping configuration to the deflectable membrane structure 14, and may comprise a substrate 18, e.g. a semiconductor substrate (e.g., Si substrate), having a through opening 18-1, e.g. a so-called Bosch cavity, between a first main surface region 18-A (e.g. a front side) and second main surface region 18-B (e.g. a back side) of the substrate 18. The through opening 18-1 has a sidewall 18-C. An insulation structure 28 is provided at peripheral portions of the membrane structure 14 and the rigid electrode structure 16. The insulation structure 28 is provided for fixing the peripheral portions of the membrane structure 14 and the rigid electrode structure 16 with respect to each other and the substrate 18. Thus, the MEMS device 10 may be arranged as a SBP (single backplate) structure, e.g. a single backplate sound transducer 10. The membrane structure 14 and the rigid electrode structure 16 may comprise a poly-Si material (Si = silicon), wherein the rigid electrode structure 16 may further comprise a SiN₄ material (intermediate) layer.

With respect to the different embodiments and alternatives of the present disclosure, it should be noted that the MEMS device 10 may be formed as a SBP (single backplate) structure (see e.g. Fig. 1a), but also as a SDM structure (see e.g. Figs 1b-c), as a DBP (dual backplate) structure, as a MEMS pressure sensor or, in general, a MEMS transducer (sensor or actuator) or a MEMS environmental sensor, wherein the MEMS device 10 comprises the (deflectable) functional element 12, e.g., with a membrane structure, in a fluidic connection with the environment. According to an embodiment, the membrane structure may comprise a circumferential shape in form of a circle, ellipse, oval, square, rectangle, hexagon, or any regular convex polygon, for example.

According to the MEMS device 10 as exemplarily shown in Fig. 1a, the functional element 12 (e.g. with a sound transducing portion) of the MEMS device 10 comprises, for example, the deflectable (movable) membrane structure 14, the rigid electrode structure (also referred to as stator, backplate or counter-electrode), the substrate 18 and the insulation structure 28.

Figs. 1b-c show a schematic cross-sectional view and a schematic top (plane) view of a MEMS device 10 in accordance with a further embodiment of the present disclosure. Fig. 1b-c and the following figures exemplarily show the MEMS device 10 in form of a dual membrane MEMS microphone or a sealed dual membrane (SDM) MEMS microphone according to various embodiments of the present disclosure. However, the following specification of the MEMS device 10 is equally applicable to any MEMS sensor or MEMS environmental sensor, wherein the MEMS device 10 comprises a (deflectable) functional element 12, e.g. a sound transducer with a membrane structure, in a fluidic connection with the environment.

As exemplarily shown in the cross-sectional view of Fig. 1b, the MEMS device 10 may be formed as a dual membrane MEMS microphone 10, which comprises the functional element 12 having a first deflectable membrane structure 14, a rigid electrode structure 16 and a second deflectable membrane structure 15 in a vertically (= along the z-direction) spaced configuration. The rigid electrode structure 16 is arranged between the first and second deflectable membrane structures 14, 15, wherein the first and second deflectable membrane structures 14, 15 each comprise a deflectable portion 14-1, 15-1. The deflectable portions 14-1, 15-1 of the first and second deflectable membrane structures 14, 15 are mechanically coupled by means of mechanical connection elements (e.g. pillars or columns) 17, to each other and are mechanically decoupled from the rigid electrode structure 16.

The MEMS device 10 in form of a (sealed) dual membrane MEMS microphone may comprise a substrate 18 having a through opening 18-1, e.g., a so-called Bosch cavity, between a first main surface region 18-A (e.g. a front side) and second main surface region 18-B (e.g., a back side) of the substrate 18.

The first deflectable (movable) membrane structure 14, the rigid electrode structure (also referred to as stator, backplate or counter-electrode) 16 and the second deflectable (movable) membrane structure 15 form a sound transducing portion (= the functional element) 12 of the MEMS device 10. The sound transducing portion 12 of the MEMS device 10 may be arranged at the first main surface region 18-A of the substrate 18 and may at least partially (or completely) span the through opening 18-1 in the substrate 18. The sound transducing portion 12 senses the pressure difference between the front and back side thereof by means of a corresponding deflection of the mechanically coupled first and second deflectable membrane structures 14, 15 with respect to the rigid electrode structure 16. According to an embodiment, the cavity or space 20 between the first and second membrane structures 14, 15 may be open, e.g., by means of an opening 22 or a plurality of openings (perforation), against the environment. Alternatively, the cavity 20 between the first and second membrane structures 14, 15 may be closed, with a laterally closed through-hole (ventilation hole) 24, or even hermetically closed (sealed) against the environment, e.g. to provide a sealed dual membrane (SDM) MEMS microphone 10. The sealed configuration can provide an improved protection against dust and moisture ingress.

The terms "electrode" and "structure" are intended to illustrate that the membrane structure(s) 14, 15 and the rigid electrode structure 16 can respectively comprise a semiconductive or conductive layer or, also, a layer sequence or layer stack having a plurality of different layers, wherein at least one of the layers is electrically conductive, e.g., comprises a metallization layer and/or a conductive semiconductor (e.g., poly-silicon) layer.

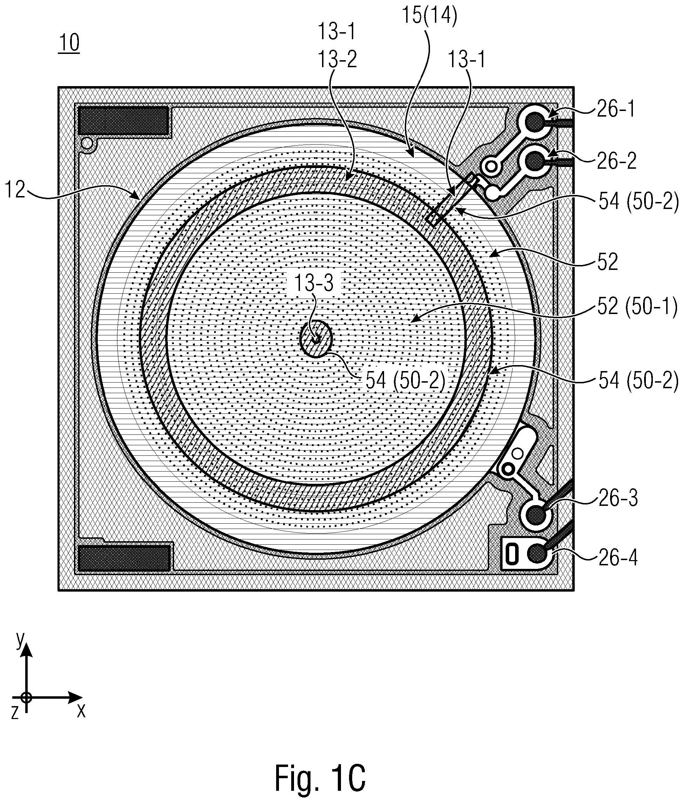

As shown in the exemplary plan view of Fig. 1c, the MEMS device 100 may further comprise electrical contact elements 26-1, 26-2, 26-3, 26-4 for providing an electrical connection to further electric components or circuits, e.g. an ASIC (ASIC = application specific integrated circuit). An insulation structure 28 is provided between peripheral portions of the membrane structures 14, 15 and the rigid electrode structure 16. The insulation structure 28 is provided for fixing the peripheral portions of the membrane structures 14, 15 and the rigid electrode structure 16. The electrical contact elements 26-1, 26-2, 26-3, 26-4 may be arranged in or at the insulation structure 28. The insulation structure 28 may, for example, comprise a SiOz material based on a tetraethyl orthosilicate (TEOS) deposition process.

In the sealed dual membrane (SDM) configuration, the first and second membrane structures 14, 15 are arranged in a hermetically sealed configuration, wherein the cavity 20 is formed therebetween. The sealed cavity 20 is formed as an encapsulation structure or vacuum chamber enclosing a reduced atmospheric pressure when compared to the environmental pressure, wherein, for example, the reduced atmospheric pressure in the low pressure region is vacuum or near to vacuum, e.g., less than about 10% or 1% of the ambient pressure or the standard atmospheric pressure (101.325 kPa) or, for example, less than 50, 20 or less than 5 kPa. Upon a deflection ±Δz of the first and second (mechanically coupled) membrane structures 14, 15, relative to the rigid electrode structure 14, that deflection or displacement can be capacitively readout in order to provide an output signal dependent on the deflection (gap change) with respect to the rigid electrode structure 16. According to a further embodiment, the transduction mechanisms may also include a piezoelectric, piezoresistive, or optical sensing scheme.

According to the MEMS device 10 as exemplarily shown in Figs. 1b-c, the functional element 12 (= the sound transducing portion) of the MEMS device 10 comprises the first and second mechanically coupled membrane structures 14, 15 and, for example, the rigid electrode structure (if in fluidic connection with the environment) 16, the substrate 18 and the insulation structure 28.

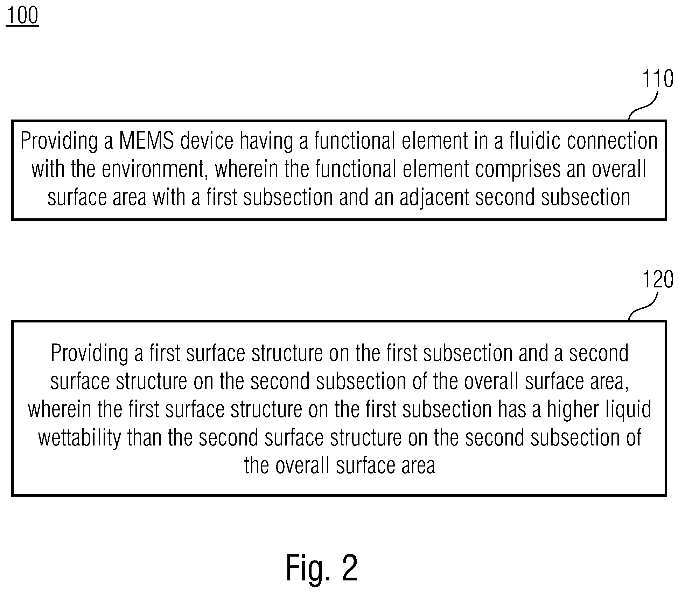

Fig. 2 shows an exemplary schematic flow chart of a fabrication method 100 of the MEMS device 10 according to an embodiment of the present disclosure.

According to an embodiment, the fabrication method comprises the steps of providing 110 a MEMS device 10 having a functional element 12 in a fluidic connection with the environment, wherein the functional element 12 comprises an overall surface area 50 with a first subsection 50-1 and an adjacent or directly adjacent second subsection 50-2, and of providing (forming) 120 a first surface structure 52 on the first subsection 50-1 of the overall surface area 50 having a higher liquid wettability than a second surface structure 54 on the second subsection 50-2 of the overall surface area 50.

According to an embodiment, the step of providing the first surface structure 52 on the first subsection 50-1 of the overall surface area 50 comprises at least one of providing (forming) a more hydrophilic base material compared to the second surface structure 54, nano-or micro-pillars, a locally deposited or patterned SAM, a selectively laser-processed surface structure, a nanoparticle structure, a nano-patterning, a nano-patterning combined with a liquid or lubricant infusion, a nano-patterning combined with a SAM coating, and a structure of printed hydrophilic nanoparticles or SAMs on the first subsection 50-1 of the overall surface area 50.

According to an embodiment, the step of providing a second surface structure 54 on the second subsection 50-2 of the overall surface area 50 comprises at least one of providing (forming) a more hydrophobic base material compared to the first surface structure 52, nano- or micro-pillars, a locally deposited or patterned SAM, a selectively laser-processed surface structure, a nanoparticle structure, a nanocarbon coating such as graphitic or diamond like carbon, a chemically modified nanocarbon coating, a nano-patterning, a nano-patterning combined with a liquid or lubricant infusion, a nano-patterning combined with a SAM coating, and a structure of printed hydrophobic nanoparticles or SAMs on the second subsection 50-2 of the overall surface area 50.

According to an embodiment, the method 100 further comprises a step of forming a (topographical) difference or gradient of the liquid contact angle on the overall surface area 50 of the functional element 12 for providing the first and second subsections 50-1, 50-2 having the different liquid wettabilities.

Before describing further embodiments, it should be noticed that in the present description of embodiments, same or similar elements having the same structure and/or function are provided with the same reference numbers or the same name, wherein a detailed description of such elements will not be repeated for every embodiment. Thus, the above description with respect to Figs. 1a-c and 2 is equally applicable to the further embodiments as described below. In the following description, essentially the differences or additions, e.g. additional elements or method steps, to the embodiment as shown in Fig. 1a-c, 2 and the technical effect(s) resulting therefrom are discussed in detail.

Figs. 3a-d show schematic cross-sectional views of a partial section of the surface area 50 of the functional element 12 of the MEMS device 10 according to embodiments of the present disclosure during a drying process after an exposure of the functional element 12 to a liquid 40 having contaminants and/or particles 48.

As exemplarily shown in Fig. 3a, the surface area 50 of the functional element 12 is at least partially or completely covered with the liquid 40, e.g. due to an immersion of the MEMS device 10 into the liquid 40, e.g. tap-water. Due to the fluid connection of the functional element 12 with the environment, the immersion of the MEMs device 10 into the liquid, results in the wetting of the surface area 50 of the functional element 12. Contaminants and/or partials 48 may be (equally) distributed in the liquid 40.

As exemplarily shown in Fig. 3b, during the drying process of the surface area 50 of the functional element 12, droplets 42 of the liquid 40 are guided to the more hydrophilic surface areas 50-1 (first subsections 50-1 of the overall surface area 50).

As shown in Fig. 3c, the second subsections (more hydrophobic or less hydrophilic parts) 50-2 of the overall surface area 50 form a liquid repelling region during a liquid drying event of the functional element 12, wherein the more hydrophilic parts (first subsections 50-1) of the overall surfaced area 50 act as liquid collection regions (water collection regions) during the drying process. Thus, the droplet(s) 42 is/are guided to more hydrophilic areas 50-1 of the functional element 12 during the drying process.

As finally shown in Fig. 3d, after the surface drying of the wetted functional element 12, the liquid residuals (contaminants and/or particles) 48 are accumulated or sedimentary deposited in the more hydrophilic region(s) (first subsections 50-1) of the overall surface area 50 of the functional element 12.

To summarize, uncritical areas (first subsections) 50-1 of the functional element 12 of the MEMs device 10 are formed to be (more) hydrophilic or less hydrophobic than critical areas (second subsections) 50-2 of the overall surface area 50 of the functional element 12 of the MEMs device 10. Thus, during a drying process, liquid droplets will move to the (more) hydrophilic or less hydrophobic areas which act as drying regions. Consequently, there are ideally no contamination particles on the critical areas 50-2 of the functional element 12 after drying the droplet(s) 42.

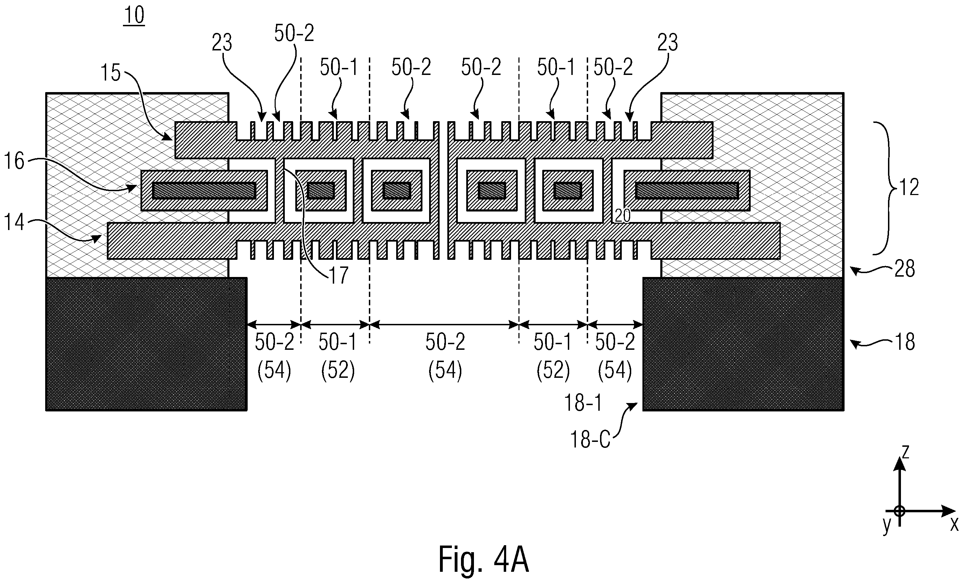

Figs. 4a shows a schematic cross-sectional view of the MEMS device 10 with an exemplary implementation of the surface structure 52, 54 of the functional element in accordance with a further embodiment of the present disclosure.

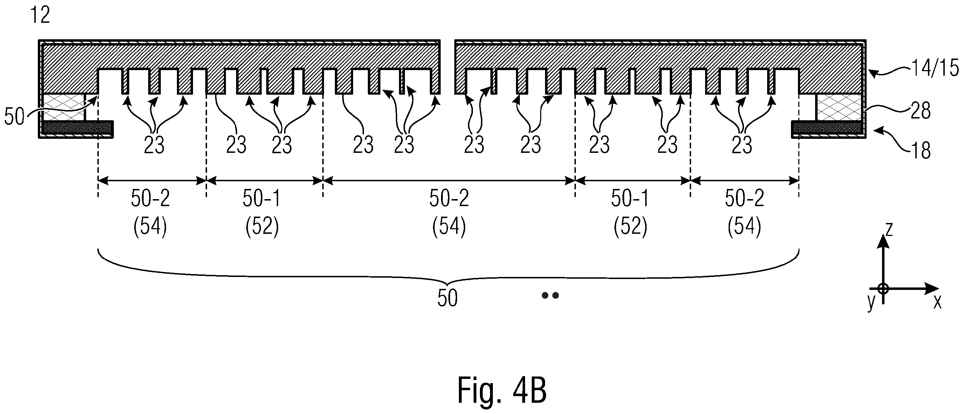

Fig. 4b shows an enlarged schematic cross-sectional partial view of the functional element 12 of the MEMS device 10 with an exemplary implementation of the surface structure of the functional element in accordance with a further embodiment of the present disclosure.

As exemplarily shown in Fig. 4a, the surface structure 52, 54 of the functional element 12 may comprise nano-/micro-structures 23, such as nano-pillars (nano-columns) or micro-pillars (micro-columns), nano-/micro-fins, nano-/micro-cones, and laser-induced periodic surface structures (LIPSS) 23. The lateral diameter of the nano-structures (e.g. nano-pillars) may be in the range of 10 to 1000 nm and of the micro-structures (e.g. micro-pillars) may be in the range of 1 to 10 µm. In general, the geometrical dimensions (the lateral cross-section areas) of the nano/micro-structures 23 are chosen to provide a liquid contact angle gradient or gradient difference along the overall surface area 50 of the functional element 12. The nano/micro-structures 23 may be configured to provide (rectangular, circular or oval) posts or pillars with a distributed change of the lateral cross-sectional area and spacing (distance) to provide a linear gradient change or a step-wise gradient difference of the liquid contact angle on the surface area 50 of the functional element 12.

Thus, the more hydrophilic parts 50-1 (having the first surface structure 52) of the surface area 50 of the functional element 12, i.e., the first subsection(s) 50-1 of the overall surface area 50, which have a higher liquid wettability than the second subsection(s) 50-2 (having the second surface structured 54) of the overall surface area 50 act as a liquid collection region(s) during the drying process of the functional element 12 after an exposure of the functional element 12 to a liquid. The second subsection(s) 50-2 of the overall surface area 50 form a liquid repelling region during a liquid drying event of the overall surface area of the functional element 12.

As exemplarily shown in Figs.4a-b, MEMS device 10 with the functional element 12 in form of a SDM microphone comprises a gradient nano-patterning 52, 54 of both the top and bottom membrane structures 14, 15. The nano-patterning 52, 54 of the first and second membrane structures 14, 15 of the functional element 12 may be formed either by laser processing or photolithography-combined etching. The design of the nanostructures (nano- or micro-patterns) provides a (linear or step-wise) topographical gradient.

It should be further noted that, according to a further embodiment, the gradient nano-patterning 52, 54 may be formed individually either on the bottom membrane 14 or on the top membrane 15, so that the local hydrophobicity gradients can be provided either on the top side or on the bottom side of the functional element 12 of the MEMS device 10. Thus, the surface modification can be done on at least one (= on one or on both) of the membrane structures 14, 15 of the functional element 12.

According to a further embodiment, the gradient nano-patterning 52, 54 may be also selectively formed on the sidewall 18-C of the through opening (Bosch cavity) 18-1, which may also form a part of the surface area 50 of the functional element 12, to provide the first surface structure 52 (e.g., a more hydrophilic structure or coating) of the first surface area 50-1 on the exposed inner surface 18-C of the through opening 18-1 of the substrate 18 or to provide a linear gradient change or a step-wise gradient difference of the liquid contact angle on the sidewall 18-C of the through opening (Bosch cavity) 18-1.

To summarize, uncritical areas 50-1 of the functional element 12 are formed to be (more) hydrophilic or less hydrophobic than critical areas 50-2 of the functional element 12 resulting in a wettability gradient between the critical and uncritical areas 50-2, 50-1 of the MEMs device. During a drying process of the functional element 12, droplets 42 will form and move to the more hydrophilic or less hydrophobic areas 50-1 of the functional element 12. Thus, ideally there is no contamination on the critical areas 50-2 when the droplets 42 are dried. To achieve the movement of the droplets from the critical areas 50-2 to the uncritical areas 50-1 of the functional element 12, only a sufficiently large gradient of the wettability is necessary, wherein a "super hydrophobicity" of the surface region 50 is not required.

With respect to the following description of further embodiments of the fabrication method 100 for providing the MEMS device 10 having the functional element 12, it should be further noted that the respective surface modification 52, 54 according to the different implementations of fabrication method 100 may be individually formed either on the bottom membrane 14 or on the top membrane 15, so that the local hydrophobicity gradients or differences can be provided either on the top side or on the bottom side of the functional element 12 of the MEMS device 10. Thus, the surface modification can be done on at least one (= on only one or on both) of the membrane structures 14, 15 of the functional element 12. In addition, a respective surface modification 52, 54 may be also selectively formed on the sidewall 18-C of the through opening (Bosch cavity) 18-1, which may also form a part of the surface area 50 of the functional element 12.

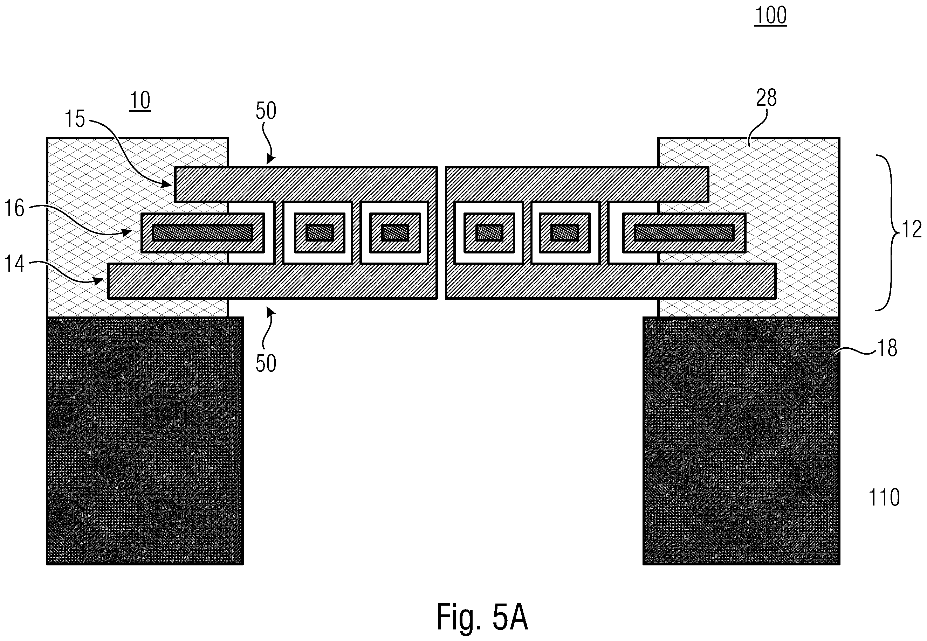

Figs. 5a-c show an exemplary schematic flow chart of an implementation of the fabrication method 100 for providing the MEMS device 10 having the functional element 12 with the different (first and second) surface structures 52, 54 of the overall surface area 50 according to an embodiment of the present disclosure.

According to an embodiment, the fabrication method 100 comprises the step of providing 110 the MEMS 10 device having the functional element 12 in a fluidic connection with the environment, wherein the functional element 12 comprises an overall surface area 50 with a first subsection 50-1 and an adjacent second subsection 50-2. As exemplarily shown in Fig. 5a, a sealed-dual membrane (SDM) MEMS device 10 having the functional element 12 is provided (fabricated). As exemplarily shown in Figs. 5a-c, the functional element 12 (= the sound transducing portion) of the MEMS device 10 comprises the first and second deflectable (movable) membrane structures 14, 15 and, optionally, the rigid electrode structure (if in fluidic connection with the environment) 16, the substrate 18 and the insulation structure 28.

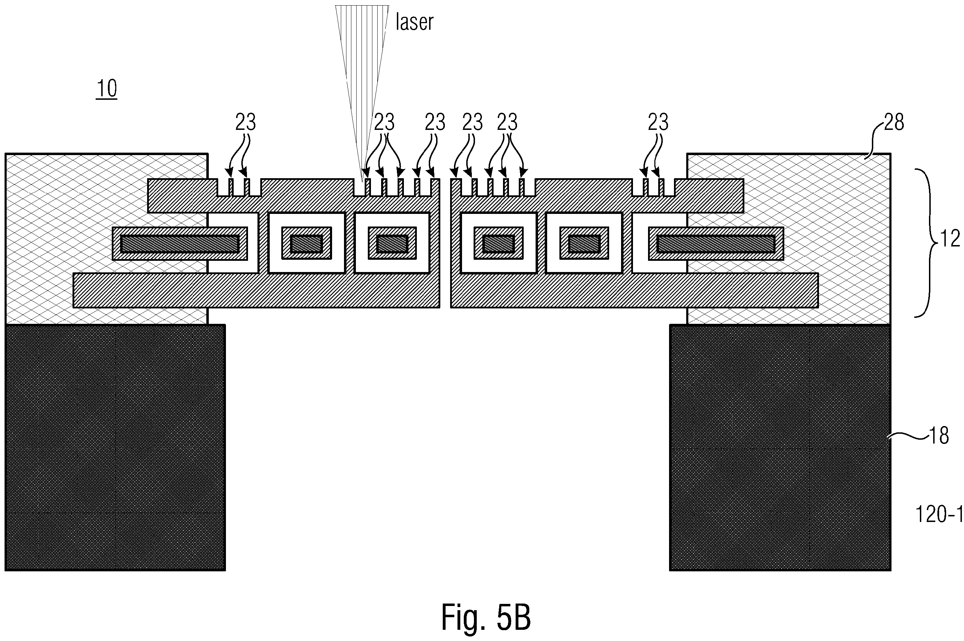

Further, Figs. 5b-c exemplarily show the step 120 (having the partial steps 120-1 + 120-2) of providing (e.g., forming) the first surface structure 52 on the first subsection 50-1 of the overall surface area 50 having a higher liquid wettability than the second surface structure 54 on the second subsection 50-2 of the overall surface area 50.

To be more specific, as exemplarily shown in Fig. 5b, a selective laser patterning 120-1 is conducted on the top membrane structure 15 as a subtractive method for providing the nano-/micro-structures 23, such as nano-pillars (nano-columns) or micro-pillars (micro-columns) 23. Other nano-/microstructures 23 (e.g., nano-/microfins, nano-/microcones, and laser-induced periodic surface structures (LIPSS)) can be also created depending on the employed laser parameters. Their geometries (e.g., depth/height and width of the structures) are adjustable. Various laser types are applicable for this purpose (e.g., picosecond laser, femtosecond laser, and nanosecond laser). As exemplarily shown in Fig. 5b, the laser-patterned surface region 50-2 has a hydrophobic characteristic, wherein the remaining surface region 50-1 (without or with a reduced laser patterning) has a hydrophilic characteristic (surface property).

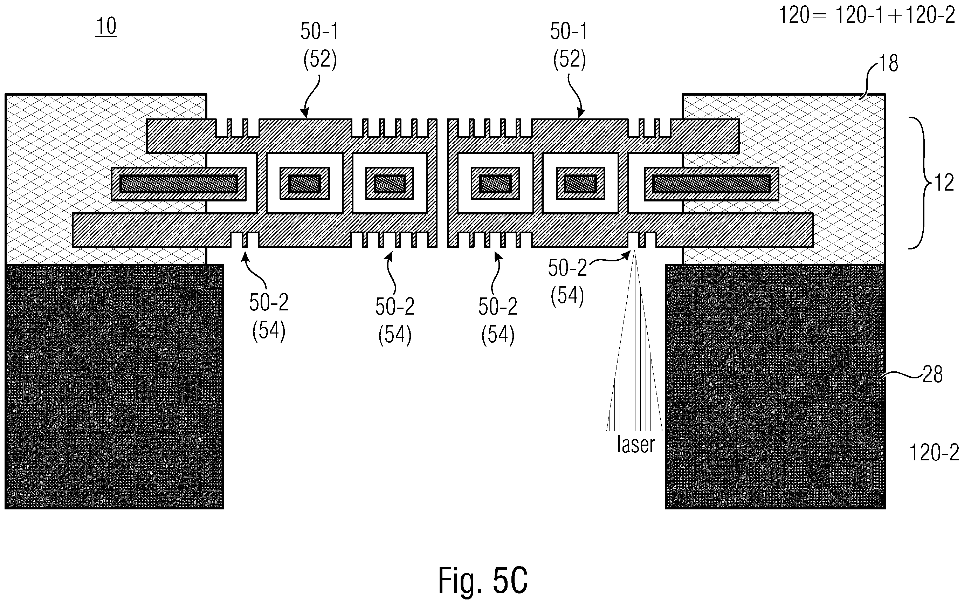

As exemplarily shown in Fig. 5c, a selective laser patterning 120-2 is conducted on the bottom membrane structure 14 for providing the nano-/micro-structures 23, wherein the laser beam is directly headed through the Bosch cavity 18-1 of the substrate 18.

Thus, Figs. 5a-c show a possible realization of the fabrication method 100 based on a laser processing, wherein the first surface structure 52 on the first subsection 50-1 and a second surface structure 54 on the second subsection 50-2 of the overall surface area 50 is provided (formed) on the functional element 12 of the MEMS device 10, wherein the first surface structure 52 on the first subsection 50-1 has a higher liquid wettability than the second surface structure 54 on the second subsection 50-2 of the overall surface area 50 of the functional element 12. In general, the geometrical dimensions (the lateral cross-section areas) of the nano-/micro-structures 23 are chosen to provide a liquid contact angle gradient or gradient difference along the overall surface area 50 of the functional element 12.

Such a laser process is less expensive when compared to a conventional photolithography process followed by an etching process (e.g., reactive ion etching (RIE)) or a bottom-up growth/deposition process. As shown in Fig. 5c, the laser beam can directly reach the bottom membrane 14 to remove the unwanted material (to pattern the bottom membrane structure 14) while in case of a photolithography process, a homogenous spin coating of the resist material is difficult to realize in view of the high aspect ratio of the Bosch cavity, (i.e., trench/cavity with a height of about 400 µm). Moreover, the laser beam can penetrate to the area close to the etched Bosch cavity edge resulting in a possibility of structuring the membrane edge. These advantages are mainly gained when the functional devices 12 that have been almost completely fabricated on the wafer (e.g., metallization process has been conducted) are used or subjected to be nano-/micro-structured. The laser structuring is a physical process, thus chemical solution is not needed to cover the target surface.

To summarize, Figs. 5a-c show a subtractive method 100 for providing selectively laser-patterned structures 52, 54, i.e., the first surface structure 52 on the first subsection 50-1 and the second surface structure 54 on the second subsection 50-2 on the bottom and top membrane 14, 15, so that the functional element 12 of the MEMs device 10 having local hydrophobicity gradients can be provided.

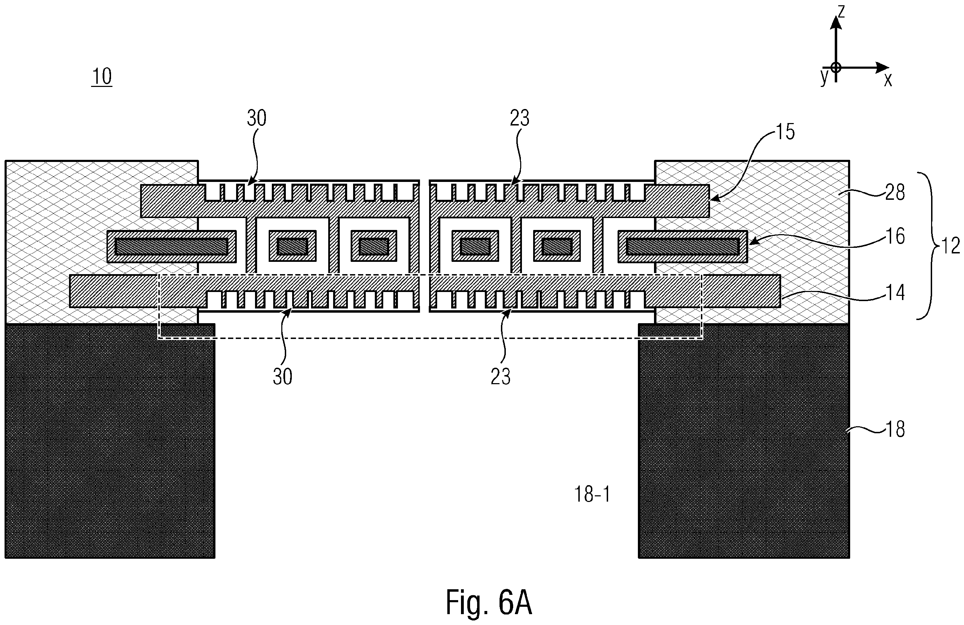

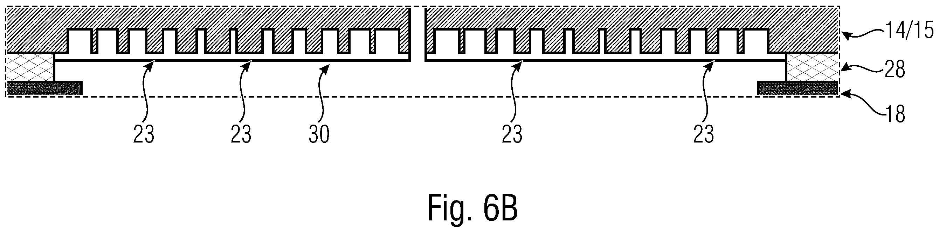

Figs. 6a-b show a schematic cross-sectional view and an enlarged schematic cross-sectional partial view of the MEMS device 10 with an exemplary implementation of the surface structure 52, 54 of the functional element 12 in accordance with a further embodiment of the present disclosure.

As exemplarily shown in Figs. 6a-b, the gradient nano- or micro-patterning 52, 54 as described with respect to Figs. 4a-b and 5a-c may be combined with an infusion of a liquid and/or lubricant 30. According to an embodiment, the first and second subsections 50-1, 50-2 of the overall surface area 50 of the functional element 12 may be (at least partially or completely) covered with the lubricant 30. The lubricant 30 is a substance that helps to reduce friction between surfaces in mutual contact. The lubricant 30 is deposited to and between the gradient nano- or micro-structures 23 to enhance a movement control of the liquid droplets (e.g. water droplets) 42, i.e., adding a "slippery" effect. According to an embodiment, different types of lubricants 30 may result in different directions of the movement of the liquid (water) droplets 42. To be more specific, the specific type of the lubricant 30 can define which regions form the first (uncritical) and the second (critical) subsections 50-1, 50-2 of the overall surface area 50 of the functional element 12.

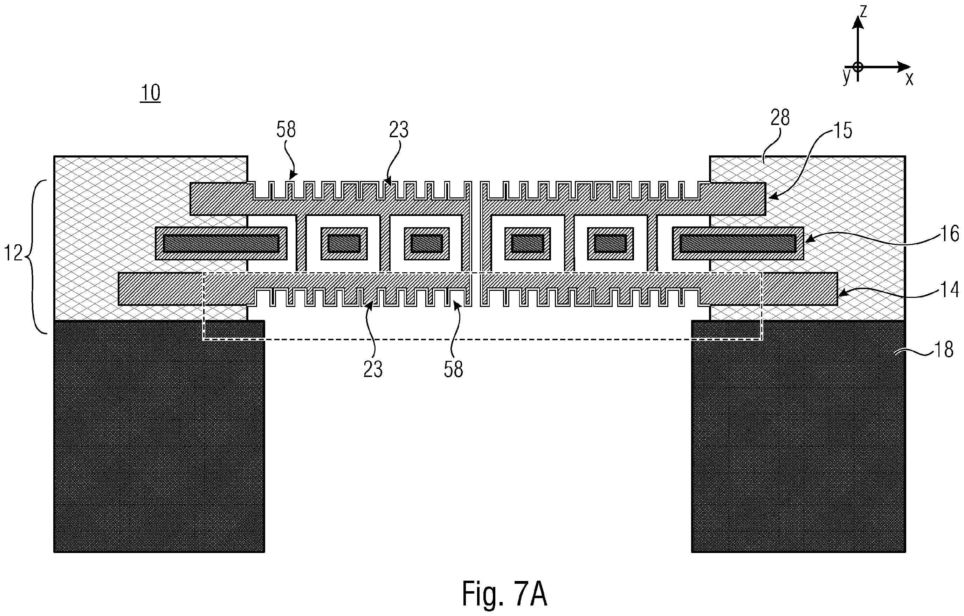

Figs. 7a-c show a schematic cross-sectional view and enlarged schematic cross-sectional partial views of the MEMS device 10 with an exemplary implementation of the surface structure of the functional element 12 in accordance with a further embodiment of the present disclosure.

As exemplarily shown in Figs. 7a-b, the gradient nano-or micro-patterning 23 may be combined with a SAM coating or layer 58 (SAM = Self-Assembled Monolayer). Thus, the SAM layer 58 is coated on the gradient nano- or micro-structures 52, 54 of the functional element 12. To improve the robustness of the functional device 12 (i.e., to further avoid a possible electrical leakage on the MEMS surface), a (very) thin insulating layer 59 made of oxide (e.g., SiO₂, AlO₂, Al₂O₃, or TiOz) can be first deposited on the membranes 14, 15 prior to SAM coating, e.g., using molecular vapor deposition (MVD) or atomic layer deposition (ALD) techniques. Based on the applied SAM layer 58, the hydrophilic and hydrophobic characteristic of the different patterns of the nano- or micro-pillars 23 for providing the first and second subsections 50-1, 50-2 of the overall surface area 50 of the functional element 12 may be enhanced or amplified.

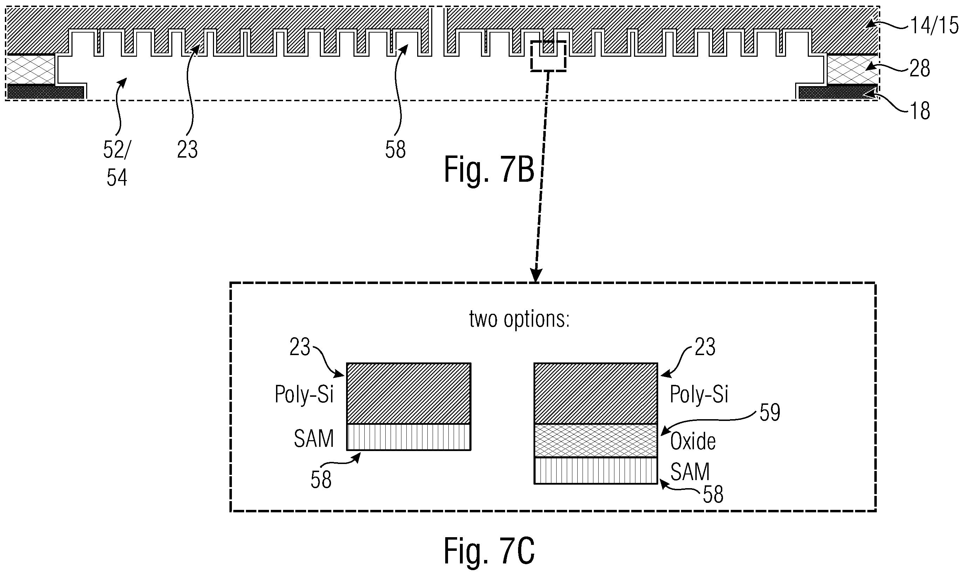

Fig. 7c further shows two enlarged schematic cross-sectional views of one of the nano- or micro-pillars 23 of Fig. 7b. According to an embodiment, the nano- or micro-pillar 23 (left element of Fig. 7c) may comprise a poly-Si material having applied thereon (only) the SAM coating or layer 58. According to a further embodiment, the nano- or micro-pillar 23 (right element of Fig. 7c) may comprise a poly-Si material having applied thereon a (thin) insulating layer 59 (e.g. an oxide layer having SiO₂, AlO₂, Al₂O₃, or TiO₂) on which the SAM coating or layer 58 is applied. The SAM coating or layer 58 may have a thickness of less than 3 nm or between 0.3 and 2.4 nm, for example. The (thin) insulating layer 59 (e.g. an oxide layer, SiO₂, AlO₂, Al₂O₃, or TiOz) may have a thickness of less than or equal to 15 nm or between 2 and 15 nm, for example.

According to an embodiment, the material for the employed SAM layer 58 may be opted from materials that either comprise per- and polyfluoroalkyl substance (PFAS) or are PFAS-free. PFAS-containing SAM materials may include FDTS (perfluorodecyltri-chlorosilane), FOTS (fluoro-octyltrichlorosilane), FOMMS, FOTES, and FOMDS. PFAS-free SAM materials may include DDMS (dichlorodimethylsilane), ODS (octadecylsilane or octadecyltrihydridosilane), ODTS (octadecyltrichlorosilane), OTS (octyltrichlorosilane), OTMS (octadecyltrimethoxysilane).

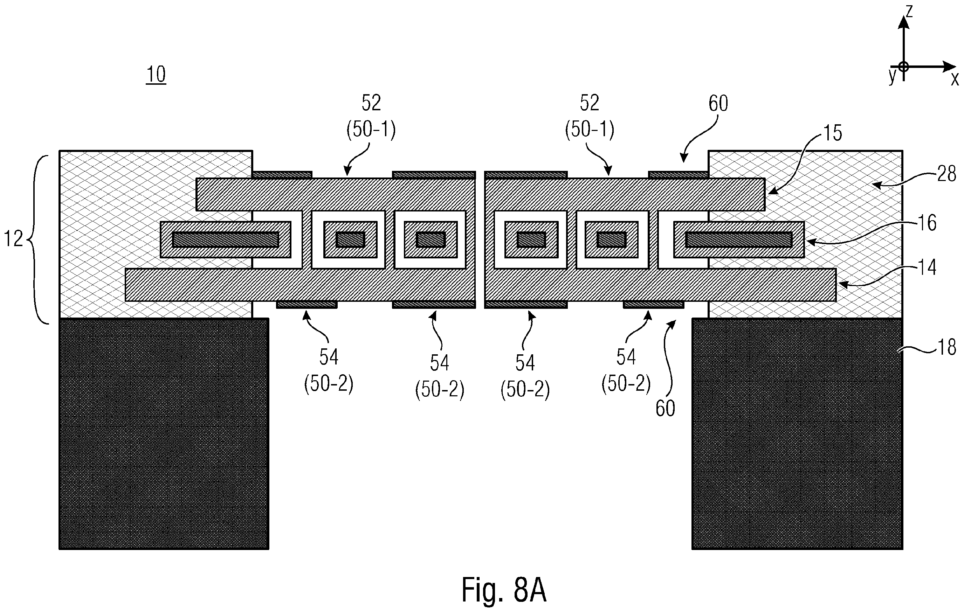

Figs. 8a-c show a schematic cross-sectional view of the MEMS device 10 with an exemplary implementation of the surface structures 52, 54 of the functional element 12, an enlarged schematic cross-sectional partial view of the surface structures 52, 54 of the functional element 12 and a schematic top (plane) view of the surface structures 52, 54 of the functional element 12 in accordance with a further embodiment of the present disclosure.

As exemplarily shown in Figs. 8a-c, the surface structure 54 of the second (critical) subsections 50-2 of the overall surface 50 of the functional element 12 may be formed by means of a patterned hydrophobic SAM 60 (self-assembled monolayer), wherein the patterned SAM 60 is formed (deposited) on the SiO₂/poly-Si-material stack (hydrophilic TEOS (SiOz) 14-A on poly-silicon 14-B) of the membrane structure 14, 15 of the functional element 12. The material of the membrane structure of the functional element 12 may comprise, for example, hydrophilic TEOS material (SiO₂). Thus, the first subsections (hydrophilic TEOS (SiO₂)) 50-1 have the first surface structure 52 with a higher liquid wettability than the second surface structure 54 of the second subsections 50-2 (the hydrophobic SAM) of the overall surface area 50 of the functional element 12. Thus, the surface area 50 of the functional element 12 may comprise a (single) hydrophobic SAM pattern 60 to form the second subsections 50-2 of the overall surface area 50. Furthermore, a very thin insulating layer made of oxide (e.g., SiO₂, AlO₂, Al₂O₃, or TiO₂) can be first deposited on the membranes prior to SAM coating, e.g., using molecular vapor deposition (MVD) or atomic layer deposition (ALD) techniques. This insulating layer is hydrophilic and can be used to enhance the functional device 12 towards electrical leakage caused by conductive contaminants that are possibly stayed on the membrane after liquid drying (dewetting) process.

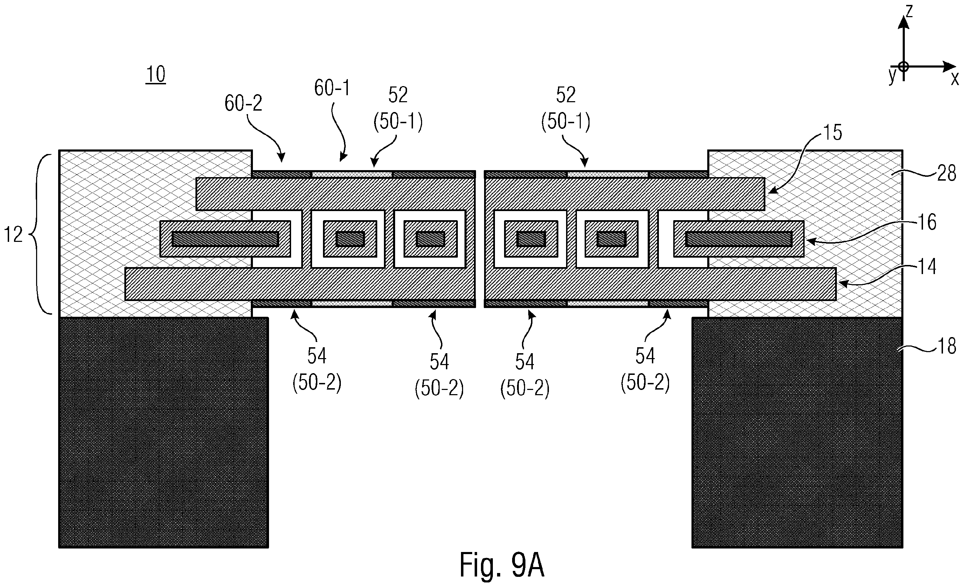

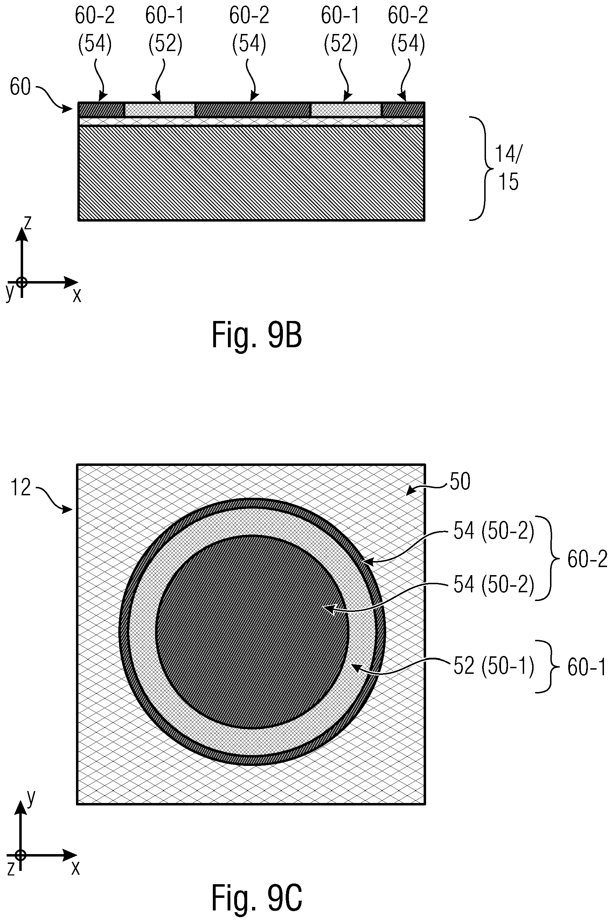

Figs. 9a-c show a schematic cross-sectional view of the MEMS device 10 with an exemplary implementation of the surface structures 52, 54 of the functional element 12, an enlarged schematic cross-sectional partial view of the surface structures 52, 54 of the functional element 12 and a schematic top (plane) view of the surface structures 52, 54 of the functional element 12 in accordance with a further embodiment of the present disclosure.

As exemplarily shown in Figs. 9a-c, a hybrid hydrophobic/hydrophilic SAM pattern 60 may be used to form the first (uncritical) and second (critical) subsections 50-1, 50-2 of the overall surface area 50 of the functional element 12. The first and the second SAM patterns 60-1, 60-2 are formed (deposited) on the oxide/poly-Si-material stack (e.g. hydrophilic TEOS (SiO₂) or AlO₂, Al₂O₃, or TiO₂ on poly-silicon) of the membrane structure 14, 15 of the functional element 12. To be more specific, as exemplarily shown in Figs. 9a-c, a (more) hydrophilic SAM pattern 60-1 may form the first surface structure 52 of the first subsection 50-1 of the functional element 12, wherein a (more) hydrophobic SAM pattern 60-2 may form the second surface structure 54 of the second subsections 50-2 of the overall surface area 50 of the functional element 12. Thus, the first subsections 50-1 have the first surface structure 52 with the (more) hydrophilic SAM pattern 60-1 with a higher liquid wettability than the second surface structure 54 of the second subsections 50-2 with the (more) hydrophobic SAM pattern 60-2 on the overall surface area 50 of the functional element 12.

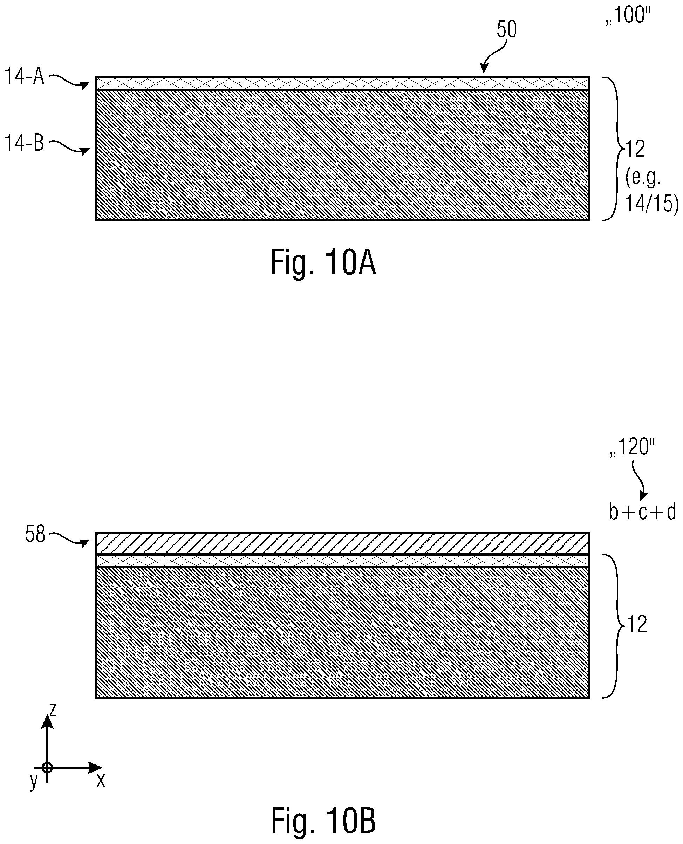

Figs. 10a-d show an exemplary schematic flow chart of a fabrication method 100 of the surface structure 52, 54 of the functional element 12 of the MEMS device 10 according to a further embodiment of the present disclosure.

According to an embodiment, the fabrication method 100 comprises the step of providing 110 the MEMS 10 device having the functional element 12 in a fluidic connection with the environment, wherein the functional element 12 comprises an overall surface area 50 with a first subsection 50-1 and an adjacent second subsection 50-2. As exemplarily shown in Fig. 10a exemplarily shows a partial view of the functional element 12 of the MEMS device 10 comprising a Si substrate 18, having SiO₂/Si stack 14-A, 14-B, or a deflectable (movable) membrane structure 14, e.g., having SiO₂/poly-Si-layer stack 14-A, 14-B. Thus, the functional element 12 may comprise, for example, a top layer having a deposited hydrophilic TEOS material (SiOz) or a naturally (thermally) grown SiOz material.

Further, Figs. 10b-d exemplarily show the step 120 of providing (e.g., forming) the first surface structure 52 on the first subsection 50-1 of the overall surface area 50 having a higher liquid wettability than the second surface structure 54 on the second subsection 50-2 of the overall surface area 50.

To be more specific, as exemplarily shown in Fig 10b, a hydrophobic self-assembled monolayer (SAM) 58 is deposited, e.g. by means of an MVD (MVD = molecular vapour deposition) or by means of an immersion on the whole surface of the functional element 12.

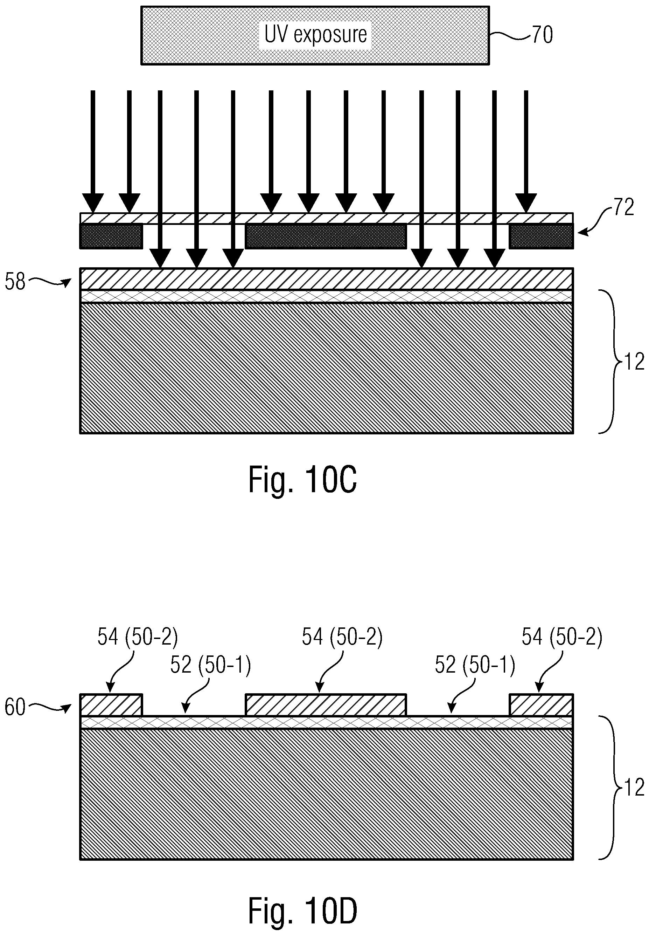

As exemplarily shown in Fig. 10c, a UV photolithography process using a UV source 70 and a photomask 72 is conducted to pattern the SAM 58. The longer the UV exposure time is, the more hydrophilic become the UV exposed regions of the SAM 58. The UV-exposed regions of the SAM become hydrophilic due to the SiOH group formation, while the non-exposed regions of the SAM 58 remain unchanged, e.g., hydrophobic octadecyl or phenyl groups in case OTS (octadecyltrichlorosilane) is opted for the SAM 58.

As exemplarily shown in Fig. 10d, the UV-exposed regions of the SAM 60 are removed, wherein the patterned hydrophobic SAM 60 on the hydrophilic SiO₂/Si layer stack (wafer) is achieved.

Thus, the exposed SiO2 layer of the functional element 12 form the first surface structure 52 on the first subsection 50-1, wherein the patterned hydrophobic SAM 60 forms the second surface structure 54 on the second subsection 50-2 of the overall surface area 50 of the functional element.

Thus, Figs. 10a-d show a possible realization of the fabrication method 100 based on the deposition of a patterned SAM 60 for providing the MEMS device 10 having the functional element 12 with local hydrophobicity gradients.

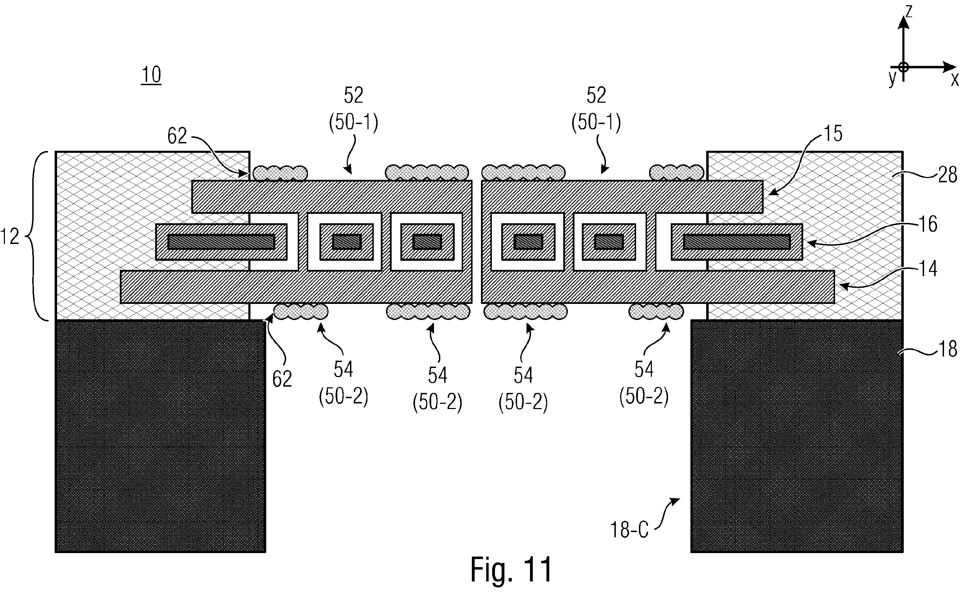

Figs. 11 shows a schematic cross-sectional view of the MEMS device 10 with an exemplary implementation of the surface structures 52, 54 of the functional element 12 in accordance with a further embodiment of the present disclosure;

As exemplarily shown in Fig. 11, the surface structure 54 of the second (critical) subsections 50-2 of the overall surface 50 of the functional element 12 may be formed by means of a patterned nano-particle layer 62, wherein the patterned nano-particle layer 62 is formed (deposited) on the dielectric/poly-Si-material stack (e.g. hydrophilic TEOS (SiOz), AlO₂, Al₂O₃, or TiOz on poly-silicon) of the membrane structure 14, 15 of the functional element 12. The material of the membrane structure of the functional element 12 may comprise, for example, hydrophilic TEOS material (SiO₂). Thus, the first subsections (hydrophilic TEOS (SiO₂)) 50-1 have the first surface structure 52 with a higher liquid wettability than the second surface structure 54 of the second subsections 50-2 (the hydrophobic nano-particle layer 62) of the overall surface area 50 of the functional element 12. Thus, the surface area 50 of the functional element 12 may comprise a (single) hydrophobic nano-particle layer (pattern) 62 to form the second subsections 50-2 of the overall surface area 50.

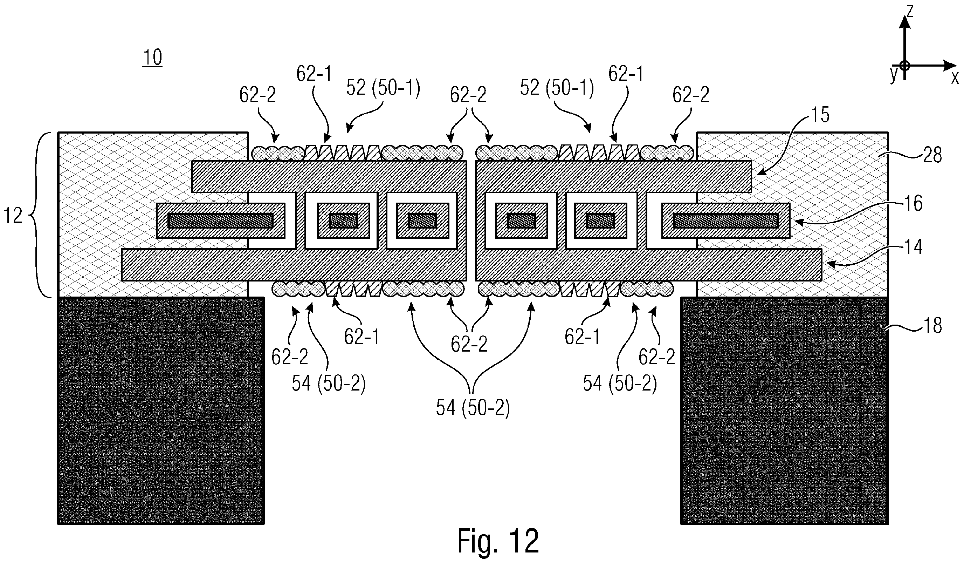

Figs. 12 shows a schematic cross-sectional view of the MEMS device 10 with an exemplary implementation of the surface structures 52, 54 of the functional element 12 in accordance with a further embodiment of the present disclosure.

As exemplarily shown in Figs. 12, a hybrid hydrophilic/hydrophobic nano-particle pattern 62-1, 62-2 may be used to form the first (uncritical) and second (critical) subsections 50-1, 50-2 of the overall surface area 50 of the functional element 12. The first and the second nano-particle patterns 62-1, 62-2 are formed (deposited), for example, on the SiO₂/poly-Si-material stack (hydrophilic TEOS (SiO₂) on poly-silicon) of the membrane structure 14, 15 of the functional element 12. To be more specific, as exemplarily shown in Fig. 12, a first nano-particle pattern 62-1 may form the first surface structure 52 of the first subsection 50-1 of the functional element 12, wherein a hydrophobic nano-particle pattern 62-2 may form the second subsections 50-2 of the overall surface area 50 of the functional element 12. Thus, the first subsections 50-1 have the first surface structure 52 with the hydrophilic nano-particle pattern 62-1 with a higher liquid wettability than the second surface structure 54 of the second subsections 50-2 with the hydrophobic nano-particle pattern 62-2 on the overall surface area 50 of the functional element 12.

As exemplarily shown in Fig. 12, a hybrid combination of hydrophilic/hydrophobic nano-particle patterns 62-1, 62-2 can be deposited (applied) to the exposed surface area 50 of the functional element 12 to form the first surface structure 52 of the first subsection 50-1 and the second surface structure 54 of the second subsection 50-2 of the functional element 12.

Examples of the hydrophilic polymer nanoparticles hydrophilic nanoparticle pattern 62-1 are:
polyethylene glycol (PEG), polyvinyl pyrrolidone (PVP), polyvinyl alcohol (PVA), polyacrylic acid (PAA), polyacrylamides, N-(2-hydroxypropyl) methacrylamide(HPMA), polyphosphates, and polyphosphazenes.

Examples of hydrophobic polymer nanoparticles for the hydrophobic nanoparticle pattern 62-2 are:
polyesters (poly(lactic acid) (PLA), poly(glycolic acid), poly(hydroxy butyrate), poly-ε-caprolactone (PCL), poly-β-malic acid, poly(dioxanones)), polyanhydrides (poly(adipic acid)), polyamides (poly(amino acids)), poly(cyanoacrylates), polyurethanes, polyortho-esters, poly(styrene) (PS), poly(lactic-co-glycolic acid) (PLGA), poly(isobutyl cyanoacrylate), poly(alkyl cyanoacrylate) (PACA), and polyacetals.

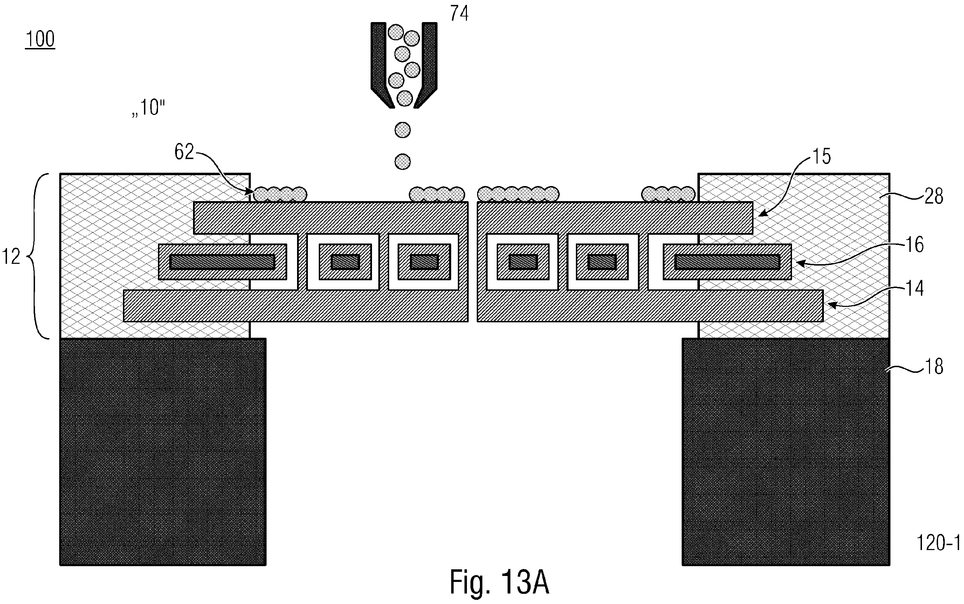

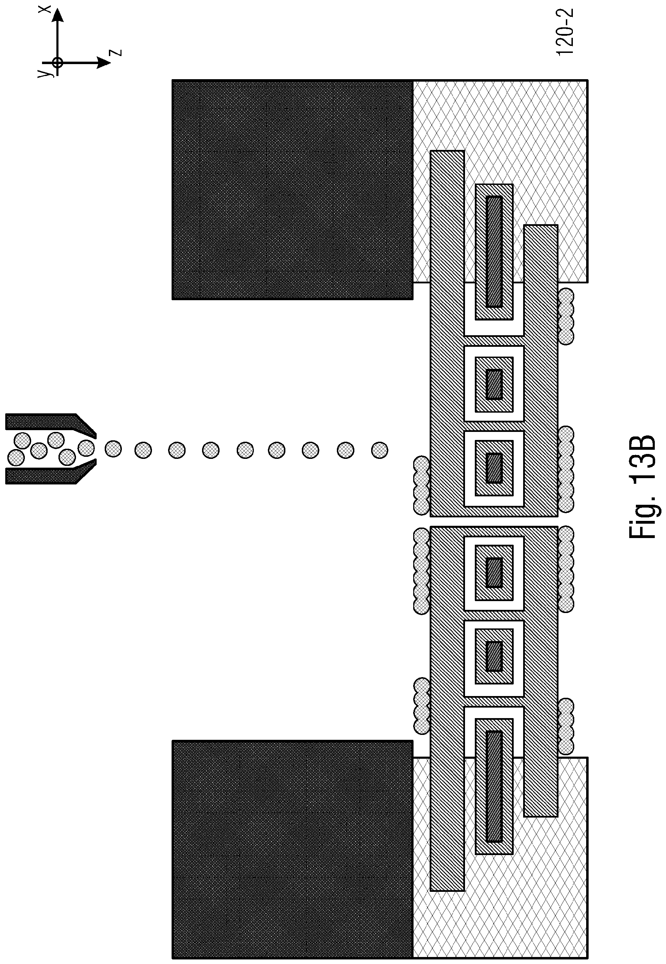

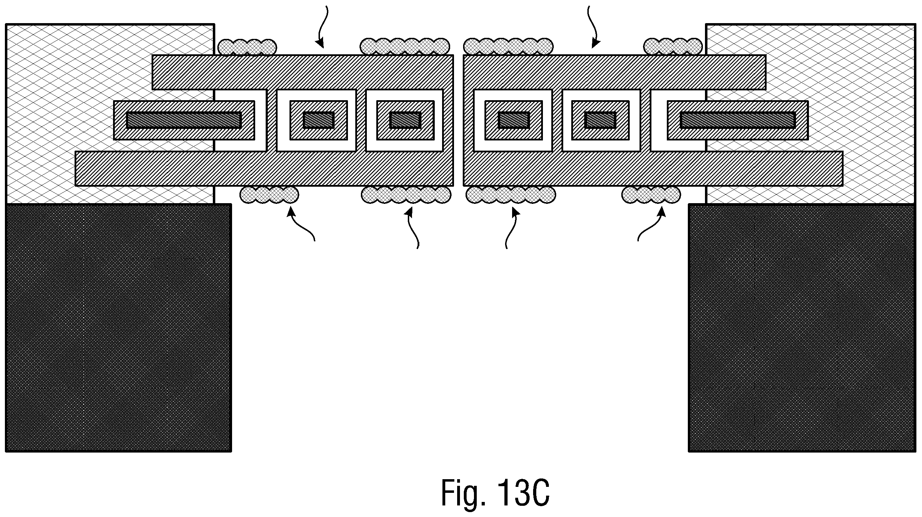

Fig. 13 shows an exemplary schematic flow chart of the fabrication method 100 of the surface structure 52, 54 of the functional element 12 of the MEMS device 10 according to a further embodiment of the present disclosure.

According to an embodiment, the fabrication method 100 comprises the step of providing 110 the MEMS 10 device having the functional element 12 in a fluidic connection with the environment, wherein the functional element 12 comprises an overall surface area 50 with a first subsection 50-1 and an adjacent second subsection 50-2. As exemplarily shown in Fig. 13a, a sealed-dual membrane (SDM) MEMS device 10 having the functional element 12 is provided (fabricated). As exemplarily shown in Figs. 13a-c, the functional element 12 (= the sound transducing portion) of the MEMS device 10 comprises the first and second deflectable (movable) membrane structures 14, 15 and, optionally, the rigid electrode structure (if in fluidic connection with the environment) 16, the substrate 18 and the insulation structure 28.

Further, Figs. 13a-c exemplarily show the step 120 (with the partial steps 120-1, 120-2) of providing (e.g., forming) the first surface structure 52 on the first subsection 50-1 of the overall surface area 50 having a higher liquid wettability than the second surface structure 54 on the second subsection 50-2 of the overall surface area 50.

To be more specific, as exemplarily shown in Fig. 13a, an hydrophobic area 62 (= second surface structure 54) on the surface area 50-2 of the top membrane 15 is created (applied) by a selective ink jet printing process of e.g. aqueous emulsions containing nano-particles/nano materials using an ink-jet printer 74 (only its nozzle is shown in Fig. 13a-b). The hydrophobic area 62 is applied (printed) as a patterned nano-material layer. According to the method, different hydrophobic nano-materials can be opted to modify the surface area 50 of the functional element 12, including metals (e.g., Ag or Au nanoparticles), carbon (e.g., graphene flakes, graphene oxide nanoparticles), and polymers (e.g., polyimide, polyamide).

As exemplarily shown in Fig. 13b, the MEMS device (wafer) 10 may be flipped and the same printing process 120-2 of nano-materials is subsequently conducted on the surface area of the bottom membrane structure 14, once the printing process 120-1 on the top membrane surface 15 has been finished.

Here, the applied nano-particles for the second surface structure 54 on the second surface area 50-2 of the functional element 12 have been dried first before conducting the printing process on the bottom membrane structure 14. Depending on the used aqueous solution, an additional heating process may be required to speed up the drying process of the applied nano-materials 62.

As exemplarily shown in Fig. 13c, the printing and drying processes 120 (120-1, 120-2) have been completed, wherein the first surface structure 52 (hydrophilic surface area) of the first (uncritical) subsection 50-1 and the second surface structure 54 of the second (critical) subsections 50-2 are obtained on the surface area 50 of the functional element 12 on both the top and bottom membrane structures 14, 15 of the functional element 12.

To summarize, Figs. 13a-c show an additive method 100 for providing selectively printed the hydrophilic/hydrophobic surface structures 52, 54 on the first and second subsections 50-1, 50-2 by printing nano-particles 62 or SAMs 60 for providing a MEMS device 10 having a functional element 12 with local hydrophobicity gradients.

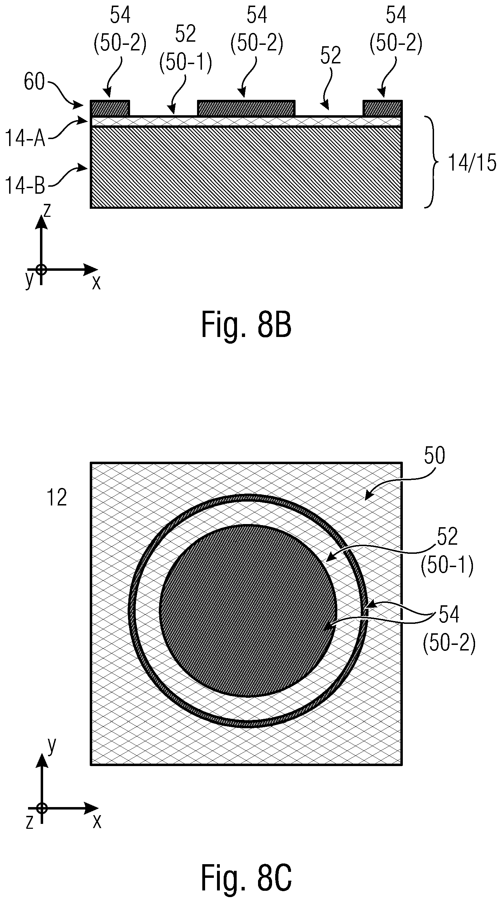

With respect to the embodiments as shown in Figs. 8 to 13, it should be noted that the different embodiments could be combined in that the first surface structure 52 of the first (uncritical) subsection 50-1 may be formed by means of a hydrophilic SAM pattern 60-1 or a hydrophilic polymer nanoparticle pattern 62-1, wherein the second surface structure 54 of the second (critical) subsection 50-2 may be formed by a hydrophobic SAM pattern 60-2 or a hydrophobic polymer nanoparticle pattern 62-2.

Thus, it is further possible to provide hydrophilic/hydrophobic nanoparticle patterns 60 or SAM patterns 62 on the surface area 50 of the functional element 12 to form the first and second subsections 50-1, 50-2 of the functional element 12. As described above, the nanoparticle patterns 62, 62-1, 62-2 may be provided by means of an additive method, e.g., a printing or ink jet printing method (= method step 120) to the surface area 50 of the functional element 12.

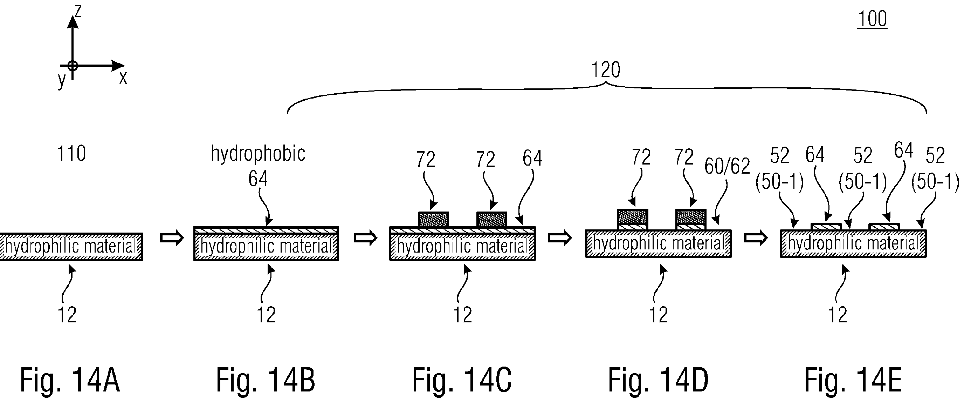

Figs. 14a-e show an exemplary schematic flow chart of a fabrication method 100 of the surface structure 52, 54 of the functional element 12 of the MEMS device 10 according to a further embodiment of the present disclosure.

According to an embodiment, the fabrication method 100 comprises the step of providing 110 the MEMS 10 device having the functional element 12 in a fluidic connection with the environment, wherein the functional element 12 comprises an overall surface area 50 with a first subsection 50-1 and an adjacent second subsection 50-2.

As exemplarily shown in Fig. 14a exemplarily shows a partial view of the functional element 12 of the MEMS device 10 comprising a hydrophilic material (e.g., silicon or poly-silicon) or a hydrophilic surface characteristic.

Further, Figs. 14b-e exemplarily show the step 120 of providing (e.g., forming) the first surface structure 52 on the first subsection 50-1 of the overall surface area 50 having a higher liquid wettability than the second surface structure 54 on the second subsection 50-2 of the overall surface area 50.

To be more specific, as exemplarily shown in Fig. 14b ("hydrophobic layer deposition"), a hydrophobic layer 64, e.g. diamond-like-carbon (DLC), is deposited, e.g. on the whole surface of the functional element 12. The deposited layer 64 is more hydrophobic or less hydrophilic (has a lower liquid wettability) than the material or surface characteristic of the functional element 12. In other words, the material or surface characteristic of the functional element 12 is more hydrophilic or less hydrophobic (has a higher liquid wettability) than the material of the deposited layer 64.

As exemplarily shown in Fig. 14c ("mask and patterning"), a mask and patterning step is conducted to deposit a patterned mask on the hydrophobic layer. As exemplarily shown in Fig. 14d ("etching"), the exposed regions of the hydrophobic layer are removed, wherein a patterned hydrophobic layer 64 on the hydrophilic surface (wafer) is achieved.

As exemplarily shown in Fig. 14e ("mask removal"), the patterned mask is removed wherein the exposed surface (layer) of the functional element 12 form the first surface structure 52 on the first subsection 50-1, wherein the patterned hydrophobic layer 64 forms the second surface structure 54 on the second subsection 50-2 of the overall surface area 50 of the functional element 12.

Thus, Figs. 14a-e show a possible realization of the fabrication method 100 based on the deposition of a patterned hydrophobic layer 64 for providing the MEMS device 10 having the functional element 12 with local hydrophobicity gradients. To be more specific, Figs. 14a-e show an inexpensive process flow for providing (relatively) large wettability gradients between the first and second subsections 50-1, 50-2 of the overall surface area 50 of the the functional element 12.

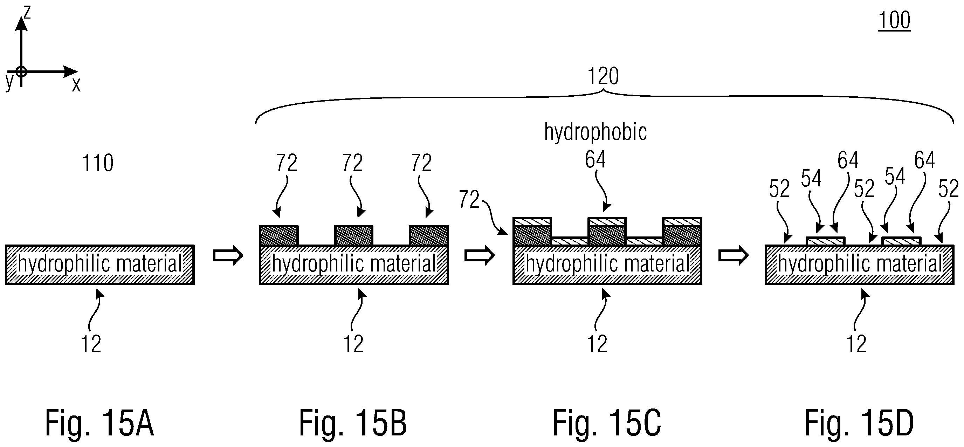

Figs. 15a-d show an exemplary schematic flow chart of a fabrication method 100 of the surface structure 52, 54 of the functional element 12 of the MEMS device 10 according to a further embodiment of the present disclosure.

According to an embodiment, the fabrication method 100 comprises the step of providing 110 the MEMS 10 device having the functional element 12 in a fluidic connection with the environment, wherein the functional element 12 comprises an overall surface area 50 with a first subsection 50-1 and an adjacent second subsection 50-2.

As exemplarily shown in Fig. 15a exemplarily shows a partial view of the functional element 12 of the MEMS device 10 comprising a hydrophilic material (e.g., silicon or poly-silicon) or a hydrophilic surface characteristic.

Further, Figs. 15b-d exemplarily show the step 120 of providing (e.g., forming) the first surface structure 52 on the first subsection 50-1 of the overall surface area 50 having a higher liquid wettability than the second surface structure 54 on the second subsection 50-2 of the overall surface area 50.

As exemplarily shown in Fig. 15b ("mask and patterning"), a mask and patterning step is conducted to deposit a patterned mask 72 on the hydrophilic surface of the functional element 12.

As exemplarily shown in Fig 15c ("hydrophilic layer deposition"), a hydrophobic layer 64, e.g. a diamond-like-carbon (DLC), is deposited on the patterned mask 72 and the exposed surface regions of the surface of the functional element 12. The deposited layer 64 is more hydrophobic or less hydrophilic (has a lower liquid wettability) than the material or surface characteristic of the functional element 12. In other words, the material or surface characteristic of the functional element 12 is more hydrophilic or less hydrophobic (has a higher liquid wettability) than the material of the deposited layer 64.

As exemplarily shown in Fig. 15d ("Lift-off"), the patterned mask (with the hydrophobic layer thereon) is removed, wherein a patterned hydrophobic layer 64 on the hydrophilic surface (wafer) is achieved. The exposed surface (layer) of the functional element 12 form the first surface structure 52 on the first subsection 50-1, wherein the patterned hydrophobic layer 64 forms the second surface structure 54 on the second subsection 50-2 of the overall surface area 50 of the functional element 12.

Thus, Figs. 15a-d show a possible realization of the fabrication method 100 based on the deposition of a patterned hydrophobic layer 64 for providing the MEMS device 10 having the functional element 12 with local hydrophobicity gradients. To be more specific, Figs. 15a-d show an inexpensive process flow for providing (relatively) large wettability gradients between the first and second subsections 50-1, 50-2 of the overall surface area 50 of the the functional element 12.

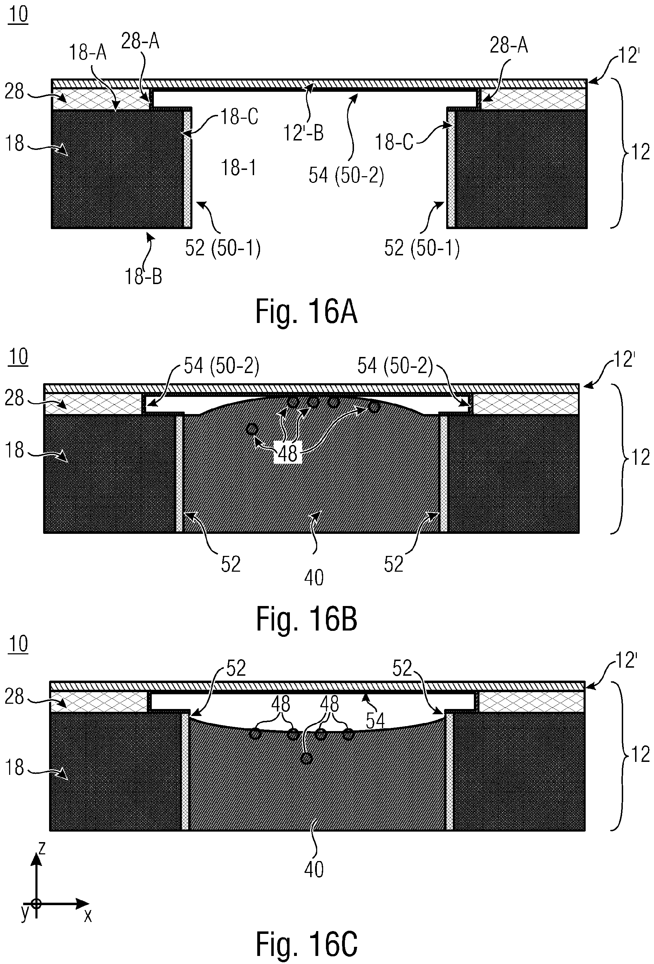

Figs. 16a-c show a schematic cross-sectional view of the MEMS device 10 with an exemplary implementation of the surface structures 52, 54 of the functional element 12 in accordance with a further embodiment of the present disclosure.

The MEMS device 10 may be formed as a SBP (single backplate) structure (see e.g. Fig. 1a), but also as a SDM structure (see e.g. Figs 1b-c), as a DBP (dual backplate) structure, as a MEMS pressure sensor or, in general, a MEMS sensor or MEMS environmental sensor, wherein the MEMS device 10 comprises the (deflectable) functional element 12, e.g. with a membrane structure, in a fluidic connection with the environment.

According to the MEMS device 10 as exemplarily shown in Figs. 16a-c, the functional element 12 of the MEMS device 10 comprises, for example, a transducer element 12', the substrate 18 and the insulation structure 28.

In case of a SBP (single backplate) structure (see e.g., Fig. 1a), the transducer element 12' may comprise the deflectable membrane structure 14 and also the rigid electrode structure 16. In case of a dual membrane MEMS microphone or a sealed dual membrane (SDM) MEMS microphone (see e.g. Fig. 1b-c), the transducer element 12' may comprise the deflectable (movable) and mechanically coupled membrane structures 14 and 15, the rigid electrode structure 16, the substrate 18 and the insulation structure 28.

The substrate 18 has a through opening 18-1, e.g., a so-called Bosch cavity, between a first main surface region 18-A (e.g., a front side) and second main surface region 18-B (e.g., a back side). The insulation structure 28 is provided for fixing the peripheral portions of the transducer element 12' to the substrate 18.

According to the embodiment as shown in Figs. 16a-c, the MEMS device 10 comprises the functional element 12 in a fluidic connection (communication) with the environment "E". The functional element 12 comprises an overall surface area 50 with at least a first subsection 50-1 and an adjacent second subsection 50-2.

As exemplarily shown in Figs. 16a-c, the first surface structure 52 (e.g., a hydrophilic coating) of the first surface area 50-1 extends on (is applied to) the exposed inner surface (sidewall) 18-C of the substrate 18. Further, the second surface structure 54 (e.g. a hydrophobic coating) of the second surface area 50-2 extends on the (exposed) second main surface region 12'-B (back side) of the transducer element 12', the exposed inner surface 28-A of the insulation structure 28, and the exposed portion of first main surface region 18-A (front side) of the substrate 18.

The first subsection 50-1 of the overall surface area 50 is configured to form a liquid collection region during a liquid drying event of the overall surface area of the functional element 12, wherein the second subsection 50-2 of the overall surface area 50 is configured to form a liquid repelling region during a liquid drying event of the overall surface area of the functional element 12.

As exemplarily shown in Figs. 16b-c, after an immersion of the functional element 12 of the MEMS device 10 into a liquid 40, e.g., tap-water, a surface contamination (e.g. as result of surface drying after exposure to a liquid) of the second (critical) subsection(s) of the overall surface area 50 can be avoided or at least significantly reduced, as the resulting liquid-drying, e.g. water-drying characteristic of the functional element 12 will move particles 48 away from the transducer element 12' into the Bosch cavity 18-1.

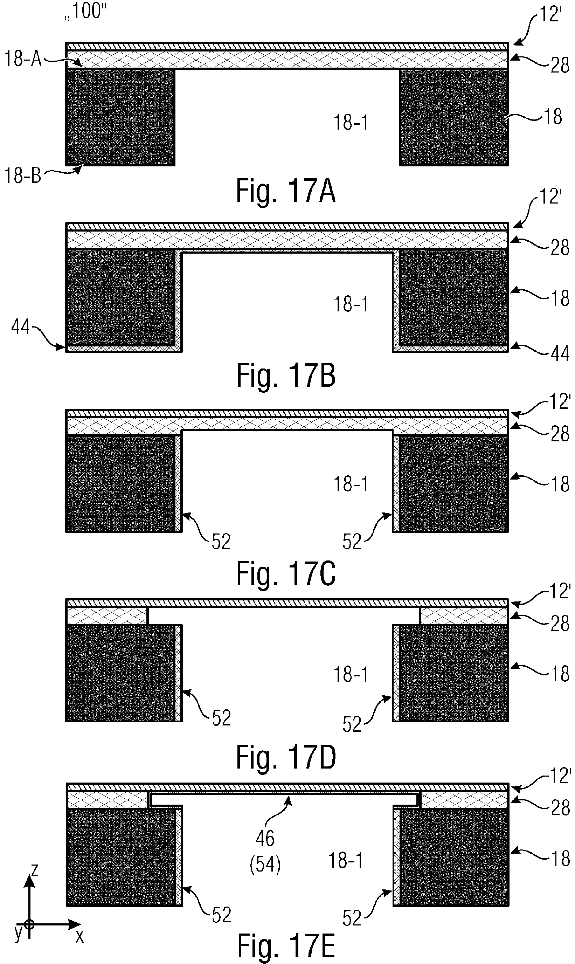

Figs. 17a-e show an exemplary schematic flow chart of a fabrication method 100 of the surface structures 52, 54 of the functional element 12 of the MEMS device 10 according to a further embodiment of the present disclosure.

As exemplarily shown in Fig. 17a, a semiconductor substrate (e.g. Si substrate) 18 with an stack comprising an insulation structure 28 and a sound transducer structure 12' on the first main surface region 18-A of the substrate is provided. As further shown in Fig. 17a, a through opening 18-1, e.g. a so-called Bosch cavity, is formed (e.g. with a Bosch cavity etch) in the substrate 18 between a first main surface region 18-A (e.g. a front side) and second main surface region 18-B (e.g. a back side).

As exemplarily shown in Fig. 17b, a back-side surface preparation, e.g. an oxidation or a MVD (molecular vapor deposition) of hydrophilic material is conducted to apply a hydrophilic material layer 44 to the (exposed) second main surface region 28-B (back side) of the insulation structure 28, the exposed (lateral) inner surface 18-C of the substrate 18 and the exposed second main surface region 18-B (back side) of the substrate 18.

As exemplarily shown in Fig. 17c, an etch process, e.g. a full area anisotropic plasma etch process, is conducted to remove the hydrophilic material layer 44 (SiOz layer or MVD layer) from the (exposed) second main surface region 28-B (back side) of the insulation structure 28 and from the exposed second main surface region 18-B (back side) of the substrate 18. The hydrophilic material layer 44 (= the first surface structure 52) remains on the exposed (lateral) inner surface 18-C of the substrate 18.

As exemplarily shown in Fig. 17d, an etch process, e.g. a final release etch, is conducted through the through opening 18-1 (Bosch cavity) to partially remove the material of the insulation structure 28 so that the remaining insulation structure 28 is provided for fixing the peripheral portions of the transducer element 12' to the substrate 18. The hydrophilic material layer 52 (= the first surface structure), which is stable during the release etch, remains on the exposed (lateral) inner surface 18-C of the substrate 18.

As exemplarily shown in Fig. 17e, a further back-side surface preparation, e.g. an oxidation or a MVD (molecular vapor deposition) of hydrophobic material (e.g. FDTS) is conducted to apply a hydrophobic material layer 46 (= the second surface structure 54 - which does not grow on the hydrophilic material layer 44) to the (exposed) second main surface region 12'-B (back side) of the transducer element 12', the exposed (lateral) inner surface 28-A of the insulation structure 28, and the exposed first main surface region 18-A (front side) of the substrate 18

Thus, based on the method 100 of Figs. 17a-e, the functional element 12 of the MEMS device 10 of Fig. 16a-c is achieved, wherein the first surface structure 52 (e.g. a hydrophilic coating) of the second surface area 50-2 extends on (is applied to) the exposed (lateral) inner surface 18-C of the substrate 18. Further, the second surface structure 54 (e.g. a hydrophobic coating) of the second surface area 50-2 extends on the (exposed) second main surface region 12'-B (back side) of the transducer element 12', the exposed (lateral) inner surface 28-A of the insulation structure 28, and the exposed first main surface region 18-A (front side) of the substrate 18.

The method 100 of Figs. 17a-e provides for a combination of hydrophilic and hydrophobic surface coating for a MEMS device 10 having a sound transducer 12' to increase environmental robustness.

Additional embodiments and aspects are described which may be used alone or in combination with the features and functionalities described herein.

According to an embodiment, a MEMS device comprises a functional element in a fluidic connection with the environment, wherein the functional element comprises an overall surface area with at least a first subsection and an adjacent second subsection, wherein the functional element is in the first subsection of the overall surface area less prone to a surface contamination than in the second subsection of the overall surface area; and wherein the first subsection of the overall surface area has a first surface structure with a higher liquid wettability than a second surface structure of the second subsection of the overall surface area.

According to an embodiment, the overall surface area of the functional element is configured so that a surface contamination of the first subsection as a result of a surface drying of the functional element after an exposure to a liquid results in a smaller deterioration of an electrical or mechanical characteristic of the functional element when compared to a corresponding surface contamination of the second subsection.

According to an embodiment, the overall surface area comprises a topographical difference or gradient of a liquid contact angle on the overall surface area resulting in the first and second subsections having the different liquid wettabilities.

According to an embodiment, the first subsection of the overall surface area is configured to form a liquid collection region during a liquid drying event of the overall surface area of the functional element.

According to an embodiment, the functional element comprises in the second subsection at least one of an electrically, mechanically and/or fluidically operating element.

According to an embodiment, the first surface structure of the first subsection comprises a lower liquid contact angle (LCA) than the second surface structure of the second subsection of the overall surface area.

According to an embodiment, the first surface structure of the first surface subsection comprises a lower hydrophobic surface characteristic than the second surface structure of the second surface subsection.

According to an embodiment, the first surface structure of the first surface subsection comprises a higher hydrophilic surface characteristic than the second surface structure of the second surface subsection.

According to an embodiment, the first surface structure of the first surface subsection has a hydrophilic surface characteristic and the second surface structure of the second surface subsection has a hydrophobic surface characteristic.

According to an embodiment, the first surface of the first surface subsection comprises at least one of a more hydrophilic base material compared to the second surface structurenano- or micro-pillars, a locally deposited or patterned SAM (SAM = self-assembled monolayer), a selectively laser-processed surface structure, a nanoparticle structure, e.g. applied by inkjet printing, a nanocarbon coating such as graphitic or diamond like carbon, a chemically modified nanocarbon coating, a nano-patterning, a nano-patterning combined with a liquid or lubricant infusion, a nano-patterning combined with a SAM coating, and a structure of printed hydrophobic nanoparticles or SAMs.

According to an embodiment, the second surface structure of the second surface subsection comprises at least one of: a more hydrophobic base material compared to the first surface structure, nano- or micro-pillars, a locally deposited or patterned SAM (SAM = self-assembled monolayer), a selectively laser-processed surface structure, a nanoparticle structure, (e.g., applied by inkjet printing), a nanocarbon coating such as graphitic or diamond like carbon, a chemically modified nanocarbon coating, a nano-patterning, a nano-patterning combined with a liquid or lubricant infusion, a nano-patterning combined with a SAM coating, and a structure of printed hydrophilic nanoparticles or SAMs.

According to an embodiment, a fabrication method comprises the steps of providing a MEMS device having a functional element in a fluidic connection with the environment, wherein the functional element comprises an overall surface area with a first subsection and an adjacent second subsection, and of providing a first surface structure on the first subsection and a second surface structure on the second subsection of the overall surface area, wherein the first surface structure on the first subsection has a higher liquid wettability than the second surface structure on the second subsection of the overall surface area.

According to an embodiment, the step of providing a first surface structure on the first subsection of the overall surface area comprises at least one of forming:
nano- or micro-pillars,
a locally deposited or patterned SAM, a selectively laser-processed surface structure, a nanoparticle structure, e.g. applied by Inkjet printing, a nanocarbon coating such as graphitic or diamond like carbon, a chemically modified nanocarbon coating, a nano-patterning,
a nano-patterning combined with a liquid or lubricant infusion, a nano-patterning combined with a SAM coating, and a structure of printed hydrophilic nanoparticles or SAMs, on the first subsection of the overall surface area.

According to an embodiment, the step of providing a second surface structure on the second subsection of the overall surface area comprises at least one of forming: nano- or micro-pillars, a locally deposited or patterned SAM, a selectively laser-processed surface structure, a nanoparticle structure, a nanocarbon coating such as graphitic or diamond like carbon, a chemically modified nanocarbon coating, a nano-patterning, a nano-patterning combined with a liquid or lubricant infusion, a nano-patterning combined with a SAM coating, and a structure of printed hydrophobic nanoparticles or SAMs, on the second subsection of the overall surface area.

According to an embodiment, the method further comprises the step of forming a topographical difference or gradient of the liquid contact angle on the overall surface area for providing the first and second subsections having the different liquid wettabilities.

Although some aspects have been described as features in the context of an apparatus, it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may, for example, be stored on a machine-readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. MEMS device (10) comprising:
A functional element (12) in a fluidic connection with the environment,
wherein the functional element (12) comprises an overall surface area (50) with at least a first subsection (50-1) and an adjacent second subsection (50-2),
wherein the functional element (12) is in the first subsection (50-1) of the overall surface area (50) less prone to a surface contamination (48) than in the second subsection (50-2) of the overall surface area (50); and
wherein the first subsection (50-1) of the overall surface area (50) has a first surface structure (52) with a higher liquid wettability than a second surface structure (54) of the second subsection (50-2) of the overall surface area (50).

2. The MEMS device (10) of claim 1, wherein the overall surface area (50) of the functional element (12) is configured so that a surface contamination (48) of the first subsection (50-1) as a result of a surface drying of the functional element (12) after an exposure to a liquid (40) results in a smaller deterioration of an electrical or mechanical characteristic of the functional element (12) when compared to a corresponding surface contamination (48) of the second subsection (50-2).

3. The MEMS device (10) of claim 1 or 2, wherein the overall surface area (50) comprises a topographical difference or gradient of a liquid contact angle on the overall surface area (50) resulting in the first and second subsections (52, 54) having the different liquid wettabilities.

4. The MEMS device (10) of any of the preceding claims, wherein the first subsection (50-1) of the overall surface area (50) is configured to form a liquid collection region during a liquid drying event of the overall surface area (50) of the functional element (12).

5. The MEMS device (10) of any of the preceding claims, wherein the functional element (12) comprises in the second surface subsection (50-2) at least one of an electrically, mechanically and/or fluidically operating element (13).

6. The MEMS device (10) of any of the preceding claims, wherein the first surface structure (52) of the first surface subsection (50-1) comprises a lower liquid contact angle (LCA) than the second surface structure (54) of the second subsection (50-2) of the overall surface area (50).

7. The MEMS device (10) of any of the preceding claims, wherein the first surface structure (52) of the first surface subsection (50-1) comprises a lower hydrophobic surface characteristic than the second surface structure (54) of the second surface subsection (50-2).

8. The MEMS device (10) of any of the preceding claims, wherein the first surface structure (52) of the first surface subsection (50-1) comprises a higher hydrophilic surface characteristic than the second surface structure (54) of the second surface subsection (50-2).

9. The MEMS device (10) of any of the preceding claims, wherein the first surface structure (52) of the first surface subsection (50-1) has a hydrophilic surface characteristic and the second surface structure (54) of the second surface subsection (50-2) has a hydrophobic surface characteristic.

10. The MEMS device (10) of any of the preceding claims, wherein the first surface structure (52) of the first surface subsection (50-1) comprises at least one of:
a more hydrophilic base material compared to the second surface structurenano- or micro-pillars,
a locally deposited or patterned SAM (SAM = self-assembled monolayer),
a selectively laser-processed surface structure,
a nanoparticle structure, e.g. applied by Inkjet printing,
a nanocarbon coating such as graphitic or diamond like carbon,
a chemically modified nanocarbon coating,
a nano-patterning,
a nano-patterning combined with a liquid or lubricant infusion,
a nano-patterning combined with a SAM coating, and
a structure of printed hydrophobic nanoparticles or SAMs.

11. The MEMS device (10) of any of the preceding claims, wherein the second surface structure (54) of the second surface subsection (50-2) comprises at least one of:
A more hydrophobic base material compared to the first surface structure,
nano- or micro-pillars,
a locally deposited or patterned SAM (SAM = self-assembled monolayer),
a selectively laser-processed surface structure,
a nanoparticle structure, (e.g. applied by Inkjet printing),
a nanocarbon coating such as graphitic or diamond like carbon,
a chemically modified nanocarbon coating,
a nano-patterning,
a nano-patterning combined with a liquid or lubricant infusion,
a nano-patterning combined with a SAM coating, and
a structure of printed hydrophilic nanoparticles or SAMs.

12. A fabrication method (100) comprising:
providing (110) a MEMS device having a functional element in a fluidic connection with the environment, wherein the functional element comprises an overall surface area with a first subsection and an adjacent second subsection, and
Providing (120) a first surface structure on the first subsection and a second surface structure on the second subsection of the overall surface area, wherein the first surface structure on the first subsection has a higher liquid wettability than the second surface structure on the second subsection of the overall surface area.

13. The method (100) of claim 12, wherein the step of providing (120) a first surface structure on the first subsection of the overall surface area comprises at least one of forming:
nano- or micro-pillars,
a locally deposited or patterned SAM,
a selectively laser-processed surface structure,
a nanoparticle structure, e.g. applied by inkjet printing,
a nanocarbon coating such as graphitic or diamond like carbon,
a chemically modified nanocarbon coating,
a nano-patterning,
a nano-patterning combined with a liquid or lubricant infusion,
a nano-patterning combined with a SAM coating, and
a structure of printed hydrophilic nanoparticles or SAMs,
on the first subsection of the overall surface area.

14. The method (100) of claim 12 or 13, wherein the step of providing (120) a second surface structure on the second subsection of the overall surface area comprises at least one of forming:
nano- or micro-pillars,
a locally deposited or patterned SAM,
a selectively laser-processed surface structure,
a nanoparticle structure,
a nanocarbon coating such as graphitic or diamond like carbon,
a chemically modified nanocarbon coating,
a nano-patterning,
a nano-patterning combined with a liquid or lubricant infusion,
a nano-patterning combined with a SAM coating, and
a structure of printed hydrophobic nanoparticles or SAMs,
on the second subsection of the overall surface area.

15. The method (100) of any of claims 12 to 14, further comprising:
Forming a topographical difference or gradient of the liquid contact angle on the overall surface area for providing the first and second subsections having the different liquid wettabilities.
